# EUROPEAN PATENT APPLICATION

(11) **EP 4 675 622 A1**
(43) Date of publication of application: **07.01.2026**
(21) Application number: 25182599.8
(22) Date of filing: 13.06.2025
(51) Int. Cl.: G11C 7/10, G11C 11/56, G11C 16/26

(54) **MEMORY DEVICE AND MEMORY CONTROLLER**

(30) Priority: 04.07.2024 KR 20240088525; 04.10.2024 KR 20240135097
(71) Applicant: Samsung Electronics Co., Ltd., Suwon-si, Gyeonggi-do 16677 (KR)
(72) Inventor: YANG, Manjae, 16677 Suwon-si (KR); PARK, Taehyeon, 16677 Suwon-si (KR); PARK, Jonghwa, 16677 Suwon-si (KR); YU, Seungwoo, 16677 Suwon-si (KR); CHO, Hwasuk, 16677 Suwon-si (KR)
(74) Representative: Marks & Clerk LLP

(57) **Abstract**

A memory device includes a memory cell array including a plurality of planes, a plurality of first FIFO memories respectively corresponding to the plurality of planes and configured to store at least some pieces of data stored in the plurality of planes, and a second FIFO memory configured to load at least some pieces of data stored in at least one of the plurality of first FIFO memories according to a plane order in which the data stored in the plurality of planes is output, wherein the memory device is configured to store the data stored in each of the plurality of planes in a corresponding first FIFO memory of the plurality of first FIFO memories, respectively, based on an initial command-address provided from a memory controller.

## Description

### BACKGROUND

The inventive concepts relate to memory devices and memory controllers, and particularly, to memory devices and memory controllers for sequentially outputting data from a memory device, based on an initial command-address, and a memory system including a memory device and a memory controller.

Recently, with the multi-functionalization of information and communication devices, large capacity and high integration of memory systems have been required. Recently developed memory systems may transmit commands and addresses through a command address bus according to a separate command address (SCA) protocol and transmit data through a data (DQ) bus. By separately configuring buses in this way, the input/output (I/O) efficiency of a memory system may be improved.

However, one memory chip of a memory device may include a plurality of planes, and when a sequential read operation is performed on the plurality of planes included in one memory chip according to the SCA protocol, command-address signals respectively corresponding to the plurality of planes may be transmitted to the memory device. It may be difficult to improve the I/O efficiency due to the delay time (for example, async time due to command-address signals respectively corresponding to the plurality of planes) that occurs when transmitting and receiving signals respectively corresponding to the plurality of planes in a memory device.

Accordingly, technology is required to further improve I/O efficiency by reducing the delay time occurring when transmitting and receiving signals respectively corresponding to a plurality of planes in a memory device.

### SUMMARY

The inventive concepts provide memory devices and memory controllers that further improve I/O efficiency by outputting data stored in each of a plurality of planes from the memory device based on an initial command-address for outputting data of an initial plane of which plane order is the first, and a memory system including the memory device and the memory controller.

According to some aspects of the inventive concepts, a memory device includes a memory cell array including a plurality of planes; a plurality of first first-in first-out (FIFO) memories respectively corresponding to the plurality of planes and configured to store at least some pieces of data stored in the plurality of planes; and a second FIFO memory configured to load at least some pieces of data stored in at least one of the plurality of first FIFO memories according to a plane order in which the data stored in the plurality of planes is output, wherein the memory device is configured to store the data stored in each of the plurality of planes in a corresponding first FIFO memory of the plurality of first FIFO memories, respectively, based on an initial command-address provided from a memory controller.

According to other aspects of the inventive concepts, a memory controller, which controls a memory device including a plurality of planes, includes a command processor configured to generate an initial command-address for instructing a memory operation for the plurality of planes and to generate an operation packet corresponding to each of the plurality of planes and instructing data stored in a corresponding operation plane to be transmitted to the memory controller; and a memory interface configured to, after the initial command-address is transmitted to the memory device, transmit the operation packet corresponding to each of the plurality of planes to the memory device according to a plane order in which data stored in each of the plurality of planes is output.

According to other aspects of the inventive concepts, a memory system includes a memory controller configured to generate an initial command-address and operation packets respectively corresponding to a plurality of planes; and a memory device configured to perform operations for the plurality of planes in response to the initial command-address and the operation packets, wherein the memory device includes a memory cell array including the plurality of planes that include an initial plane, the initial plane including data, the memory device is configured to first output data of the initial plane, and a normal plane, the normal plane including data, the normal plane having a plane order after the initial plane, the memory device is configured to output data of the normal plane after outputting data of the initial plane; and an input/output circuit configured to temporarily receive and store data stored in the initial plane and the normal plane, based on the initial command-address, and output data of an operation plane corresponding to the operation packet to the memory controller, based on the operation packet.

According to some aspects of the inventive concepts, a method of operating a memory device includes receiving, at a memory device, an initial command-address; storing, in response to the initial command-address, data read from a plurality of planes in an I/O circuit, data read from an individual plane of the plurality of planes is stored as first data; receiving, at the memory device, a first operation packet, the first operation packet corresponding to the first data; and outputting from the memory device, in response to receiving the first operation packet, the first data according to a plane order, wherein the first operation packet includes plane order information of data read from a plane of the plurality of planes.

According to some aspects of the inventive concepts, a method of operating a memory device may include wherein the first operation packet is received by the memory device during an operation time of the first data during which the first data is output.

According to some aspects of the inventive concepts, a method of operating a memory device may include wherein the first operation packet includes a plane order of a second data read from a second individual plane of the plurality of planes.

According to some aspects of the inventive concepts, a method of operating a memory device may include wherein the first operation packet includes a plane order of a second data read from a second individual plane of the plurality of planes.

According to some aspects of the inventive concepts, a method of operating a memory device may include receiving, at the memory device, a second operation packet corresponding to the second data at a second operation time during which the second data is output.

According to some aspects of the inventive concepts, a method of operating a memory device may include wherein the initial command-address includes plane order information of the first data.

According to some aspects of the inventive concepts, a method of operating a memory device may include wherein the I/O circuit includes a plurality of first first-in first-out (FIFO) memories corresponding to the plurality of planes and a second FIFO memory, and the method further includes, loading the data read from the plurality of planes to the first FIFO memories in response to receiving the initial command-address.

According to some aspects of the inventive concepts, a method of operating a memory device may include transferring the first data from the first FIFO memories to the second FIFO memory in response to receiving the first operation packet, wherein the second FIFO memory outputs the first data from the memory device.

According to some aspects of the inventive concepts, a method of operating a memory device does not include receiving a command-address subsequent to the initial command-address.

At least some of the above and other features of the invention are set out in the claims.

### BRIEF DESCRIPTION OF THE DRAWINGS

Some example embodiments of the inventive concepts will be more clearly understood from the following detailed description taken in conjunction with the accompanying drawings in which:
FIG. 1 is a block diagram illustrating a host-memory system according to some example embodiments;
FIG. 2 is a block diagram illustrating a memory controller according to some example embodiments;
FIG. 3 is a diagram illustrating a memory system according to some example embodiments;
FIG. 4 is a diagram illustrating a memory device according to some example embodiments;
FIG. 5 is a diagram illustrating a memory cell array according to some example embodiments;
FIG. 6 is a diagram illustrating an input/output circuit according to some example embodiments;
FIG. 7 is a timing diagram illustrating an initial command-address and an operation packet, according to some example embodiments;
FIG. 8 is a timing diagram illustrating an example in which each operation completion packet includes plane order information, according to some example embodiments;
FIG. 9A is a diagram illustrating an operating method of a memory device in a first operation period of FIG. 8;
FIG. 9B is a diagram illustrating an operating method of a memory device in a second operation period of FIG. 8;
FIG. 10 is a timing diagram illustrating an example in which each operation execution packet includes plane order information, according to some example embodiments;
FIG. 11A is a diagram illustrating an operating method of a memory device in a first operation period of FIG. 10;
FIG. 11B is a diagram illustrating an operating method of a memory device in a second operation period of FIG. 10; and
FIG. 12 illustrates a system to which a memory system according to some example embodiments is applied.

### DETAILED DESCRIPTION

Hereinafter, some example embodiments are described in detail with reference to the attached drawings. The same reference numerals are used for the same components in the drawings, and redundant descriptions thereof are omitted.

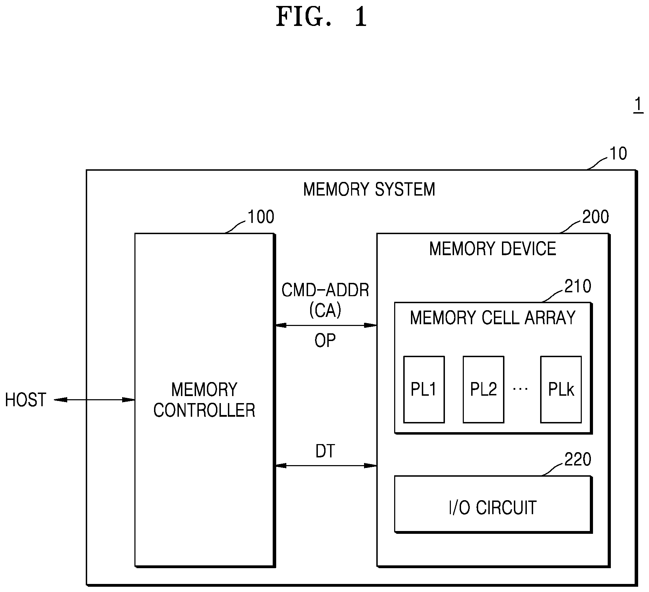

FIG. 1 is a block diagram illustrating a host-memory system according to some example embodiments.

Referring to FIG. 1, a host-memory system 1 may include a host and a memory system 10. The host may communicate with the memory system 10 through an interface. Here, the interface may be implemented by, for example, non-volatile memory express (NVMe), an NVMe management interface (MI), or NVMe over fabric (OF). The host may control all operations of the memory system 10. For example, the host may store data in the memory system 10 or read the data stored in the memory system 10.

The host may provide the memory system 10 with a write request for requesting to store data in the memory system 10. In addition, the host may provide data and a logical address for identifying the data to the memory system 10. The host may provide the memory system 10 with a read request for requesting to provide the data stored in the memory system 10. In addition, the host may provide a logical address for identifying data to the memory system 10.

The memory system 10 may include a memory controller 100 and a memory device 200. For example, the memory controller 100 and the memory device 200 may be integrated into a single semiconductor device. For example, the memory system 10 may be implemented as an internal memory built in to an electronic device and may be an embedded universal flash storage (UFS) memory device, an embedded multi-media card (eMMC), or a solid state drive (SSD). In some example embodiments, the memory system 10 may be implemented by an external memory device removable from an electronic device and may be, for example, a UFS memory card, a compact flash (CF) card, a secure digital (SD) card, a micro-SD card, a mini-SD card, an extreme digital (xD) card, or a memory stick.

The memory controller 100 may control the memory device 200 to read data stored in the memory device 200 or write (or program) data to the memory device 200 based on a request (for example, a read request or a write request) provided by the host.

The memory controller 100 may control all operations of the memory device 200. The memory controller 100 may control a memory operation for the memory device 200. The memory operation for the memory device 200 may include a write operation, a read operation, and an erase operation. The memory controller 100 may control the write operation (or a program operation), the read operation, and the erase operation for the memory device 200 by providing a command (CMD)-address (ADDR) CA to the memory device 200.

The memory controller 100 may generate the command-address CA to control a memory operation for a plane of the memory device 200. The command-address CA may include command-address information necessary for the memory controller 100 to instruct the memory device 200 to operate. The command-address CA may include at least one of command information and address information. For example, the memory controller 100 may generate the command-address CA to control a read operation for a plane and transmit the command-address CA to the memory device 200.

In some example embodiments, the memory controller 100 may generate an initial command-address and transmit the generated initial command-address to the memory device 200. The command-address CA may include an initial command-address. The initial command-address may be the command-address CA for instructing a plurality of planes PL1 to PLk included in one memory chip of the memory device 200 to perform a memory operation. For example, the initial command-address may instruct that the data stored in each of the plurality of planes PL1 to PLk included in one memory chip is stored in a memory of an input/output circuit 220. The initial command-address may instruct that the data stored in each of the plurality of planes PL1 to PLk are stored in each of registers respectively corresponding to the plurality of planes PL1 to PLk.

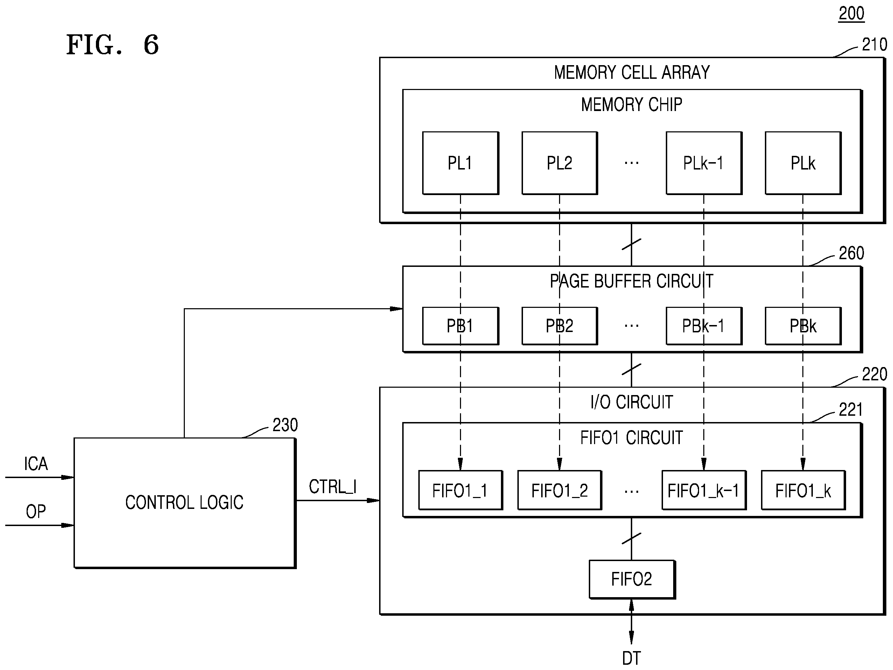

In some example embodiments, the registers respectively corresponding to the plurality of planes PL1 to PLk may be included in the input/output circuit 220. For example, the input/output circuit 220 may include a plurality of first first-in first-out (FIFO) memories (for example, first FIFO memories FIFO1 of FIG. 6) respectively corresponding to the plurality of planes PL1 to PLk, and the memory controller 100 may generate an initial command-address for controlling the memory device 200 such that the data stored in each of the plurality of planes PL1 to PLk are stored in each of the first FIFO memories respectively corresponding thereto. The input/output circuit 220 is described below in detail with reference to FIG. 6.

The memory controller 100 may generate operation packets OP. The memory controller 100 may generate the operation packets OP respectively corresponding to the plurality of planes PL1 to PLk included in one memory chip. The operation packets OP may indicate packets for instructing the data stored in operation planes respectively corresponding to the operation packets OP to be output from the memory device 200. The operation planes respectively corresponding to the operation packets OP may indicate planes in which the data output from the memory device 200 by the operation packets OP are stored. For example, data of a first plane PL1 may be output from the memory device 200 based on a first operation packet, and the first plane PL1 may be an operation plane corresponding to the first operation packet. Herein, the data stored in the planes may be referred to as data read from the planes, data respectively corresponding to the planes, data of the planes, or so on.

The memory controller 100 may generate the operation packets OP for instructing the data of the operation planes to be output from the input/output circuit 220 in which the data read from the operation planes are stored to the memory controller 100. For example, the input/output circuit 220 may include a second FIFO memory (for example, a second FIFO memory FIFO2 of FIG. 6) into which at least some pieces of the data stored in the first FIFO memories respectively corresponding to the plurality of planes PL1 to PLk are loaded. For example, the data stored in the plurality of planes PL1 to PLk may be temporarily stored in the plurality of first FIFO memories based on the initial command-address. The data loaded into the first FIFO memories may be loaded into the second FIFO memory to be output to the memory controller 100 according to a plane order in which the data is output. That is, the data stored in at least one of the plurality of first FIFO memories may be temporarily stored in the second FIFO memory according to the plane order.

The operation packet OP may instruct that the data loaded into the second FIFO memory be output to the memory controller 100. The data loaded into the second FIFO memory may be output according to the plane order.

The memory controller 100 may transmit the operation packets OP to the memory device 200 after the initial command-address is transmitted to the memory device 200. The memory controller 100 may transmit the initial command-address to the memory device 200 and sequentially transmit the operation packets OP according to the plane order. The memory controller 100 may transmit the operation packets OP respectively corresponding to the plurality of planes PL1 to PLk to the memory device 200 according to the plane order.

The plane order may refer to an order in which data stored in the plurality of planes PL1 to PLk included in one chip are output to the memory controller 100. The memory controller 100 may set the plane order. For example, the memory controller 100 may set the plane order based on a request provided from the host. However, some example embodiments are not limited thereto. For example, when the plane order is the first plane PL1, a second plane PL2, and a third plane PL3, the memory controller 100 may transmit the initial command-address, and then, may transmit a first operation packet corresponding to the first plane PL1, a second operation packet corresponding to the second plane PL2, and a third operation packet corresponding to the third plane PL3 to the memory device 200 in the listed order.

In some example embodiments, the memory controller 100 may add plane order information to the operation packets OP. The plane order information may refer to information indicating the plane order. The operation packets OP may include the plane order information. For example, the operation packets OP may include plane order information regarding the operation planes respectively corresponding to the operation packets OP. For example, the first operation packet may include plane order information regarding the first plane PL1 that is the operation plane. For example, the operation packets OP may include plane order information regarding a subsequent plane. The subsequent plane may indicate a plane following the operation plane. For example, when the plane order is the first plane PL1 and the second plane PL2, and when the operation plane is the first plane PL1, the second plane PL2 may be a subsequent plane of the first plane PL1. The first operation packet may include plane order information regarding the second plane PL2 that is a subsequent plane.

The memory controller 100 may transmit and receive transmission data DT to and from the memory device 200. Data to be written and data to read may be transmitted and received as data between the memory controller 100 and the memory device 200. For example, the data output from the memory device 200 may be transmitted to the memory controller 100 as transmission data DT.

The memory controller 100 may communicate with the host and the memory device 200. The memory controller 100 may communicate with the host through various standard interfaces. For example, the memory controller 100 may include a host interface, and the host interface may provide various standard interfaces between the host and the memory controller 100. The standard interface may include various interface types, such as advanced technology attachment (ATA), serial ATA (SATA), external SATA (e-SATA), a small computer small interface (SCSI), a serial attached SCSI (SAS), peripheral component interconnection (PCI), PCI express (PCI-E), institute of electrical and electronics engineers (IEEE) 1394, a universal serial bus (USB), a secure digital (SD) card, a multimedia card (MMC), an embedded multimedia card (eMMC), a universal flash storage (UFS), and a compact flash (CF) card interface.

The memory device 200 may include a non-volatile memory device, such as flash memory. The flash memory may include a two-dimensional (2D) NAND memory array or a three-dimensional (3D) NAND (or vertical NAND (VNAND)) memory array. In some example embodiments, the 3D memory array may include vertical NAND strings arranged vertically such that at least one memory cell is placed above another memory cell. The at least one memory cell may include a charge trap layer.

The inventive concepts are not limited thereto, and the memory device 200 may also include various other types of memories. For example, the memory device 200 may include various types of memories, such as magnetic random access memory (MRAM), spin-transfer torque MRAM, conductive bridging RAM (CBRAM), ferroelectric RAM (FeRAM), phase RAM (PRAM), resistive RAM, nanotube RAM, polymer RAM (PoRAM), nano floating gate memory (NFGM), holographic memory, molecular electronics memory, and insulator resistance change memory.

The memory device 200 may include a memory cell array 210 and the input/output circuit 220. The memory cell array 210 may include the plurality of planes PL1 to PLk. FIG. 1 illustrates the plurality of planes PL1 to PLk included in one memory chip. The plurality of planes PL1 to PLk may be included in the same memory chip. One memory chip may include k (k is a positive number of 2 or more) planes. Although FIG. 1 illustrates the plurality of planes PL1 to PLk included in one memory chip included in the memory cell array 210, the inventive concepts are not limited thereto. The memory cell array 210 may include a plurality of memory chips, and the plurality of memory chips may each include a plurality of planes.

In addition, the plurality of planes PL1 to PLk may each include a plurality of memory blocks. The plurality of memory blocks may each include a plurality of memory cells arranged in regions where a plurality of word lines intersect a plurality of bit lines. Each of the plurality of memory cells may be a multi-level cell storing 2 or more bits of data. For example, each of the plurality of memory cells may be a 2-bit multi-level cell storing 2 bits of data, a triple-level cell (TLC) storing 3 bits of data, a quadruple-level cell (QLC) storing 4 bits of data, or a multi-level cell storing more than 4 bits of data. However, the inventive concepts are not limited thereto. The memory cell array 210 may perform an erase operation of data in units of cell blocks, and also, data write and read operations may be performed in units of pages.

The input/output circuit 220 may temporarily store data. When the memory device 200 performs a read operation, the input/output circuit 220 may store at least some pieces of the data stored in the plurality of planes PL1 to PLk. The input/output circuit 220 may temporarily store the data read from the plurality of planes PL1 to PLk. The input/output circuit 220 may be connected to the memory cell array 210. For example, the input/output circuit 220 may be connected to the plurality of planes PL1 to PLk.

The input/output circuit 220 may include a plurality of registers. For example, the plurality of registers may each include FIFO memory. In some example embodiments, the input/output circuit 220 may include the plurality of first FIFO memories respectively corresponding to the plurality of planes PL1 to PLk and the second FIFO memory that temporarily stores the data stored in the plurality of first FIFO memories. For example, the input/output circuit 220 may include k first FIFO memories respectively corresponding to k planes PL1 to PLk. The first FIFO memory corresponding to the first plane PL1 may store the data read from the first plane PL1, and the first FIFO memory corresponding to the k^{th} plane PLk may store data read from the k^{th} plane PLk.

The memory device 200 may receive a command-address CA from the memory controller 100. The memory device 200 may receive transmission data DT from the memory controller 100 or transmit the transmission data DT to the memory controller 100. The memory device 200 may perform a memory operation based on the command-address CA.

The memory device 200 may receive an initial command-address CA and the operation packets OP from the memory controller 100. The memory device 200 may perform operations on planes based on the initial command-address and the operation packets OP. The memory device 200 may first receive the initial command-address and then sequentially receive the operation packets OP respectively corresponding to the plurality of planes PL1 to PLk according to a plane order.

The memory device 200 may perform a memory operation for the plurality of planes PL1 to PLk based on the initial command-address. In some example embodiments, the input/output circuit 220 may store, in the input/output circuit 220, the data read from the plurality of planes PL1 to PLk based on the initial command-address. The input/output circuit 220 may store the data stored in the plurality of planes PL1 to PLk in registers respectively corresponding to the plurality of planes PL1 to PLk. That is, the input/output circuit 220 may receive the data stored in the plurality of planes PL1 to PLk and store the received data in registers respectively corresponding to the plurality of planes PL1 to PLk based on the initial command-address.

For example, the input/output circuit 220 may temporarily store the data read from the plurality of planes PL1 to PLk in the plurality of first FIFO memories respectively corresponding to the plurality of planes PL1 to PLk based on the initial command-address. When the memory device 200 receives the initial command-address, the data stored in the plurality of planes PL1 to PLk may be moved to the input/output circuit 220 at once.

The memory device 200 may receive the operation packets OP. After receiving the initial command-address, the memory device 200 may sequentially receive the operation packets OP respectively corresponding to the plurality of planes PL1 to PLk in a plane order. After receiving the initial command-address, the memory device 200 may receive the operation packets OP respectively corresponding to the plurality of planes PL1 to PLk in the plane order.

The input/output circuit 220 may output data of the plurality of operation planes PL1 to PLk based on the operation packets OP. The input/output circuit 220 may output data of the operation planes from among the data read from the plurality of planes PL1 to PLk stored in the input/output circuit 220 based on the operation packets OP. For example, the input/output circuit 220 may output data of the first plane PL1 corresponding to the first operation packet as transmission data DT to the memory controller 100 based on the first operation packet. The input/output circuit 220 may output data of the operation plane from among pieces of the data stored in the input/output circuit 220 based on the operation packets OP based on the initial command-address.

In some example embodiments, the input/output circuit 220 may output the data loaded in the second FIFO memory to the memory controller 100 based on the operation packet OP. For example, the memory device 200 may store the data stored in the plurality of planes PL1 to PLk in the plurality of first FIFO memories corresponding to the plurality of planes PL1 to PLk based on the initial command-address. The data stored in the plurality of first FIFO memories may be loaded into the second FIFO memory to be output to the memory controller 100 in the plane order. The data of the operation planes may be loaded from the plurality of first FIFO memories to the second FIFO memory, and the input/output circuit 220 may output the data of the operation planes loaded in the second FIFO memory based on the operation packets OP. The data of the operation planes may be transmitted to the memory controller 100 as the transmission data DT.

The operation packets OP may include plane order information. At least some pieces of the data of the plurality of planes PL1 to PLk may be loaded into the input/output circuit 220 based on the plane order information. For example, based on the plane order information, data to be loaded into the second FIFO memory may be selected from among the data stored in the plurality of first FIFO memories and may be loaded into the second FIFO memory.

In some example embodiments, the memory device 200 may receive the operation packets OP including the plane order information regarding the operation planes. For example, the input/output circuit 220 may load data of the operation plane from the first FIFO memory corresponding to the operation plane to the second FIFO memory based on the plane order information of the operation packet OP. The input/output circuit 220 may output the data of the operation plane loaded in the second FIFO memory as the transmission data DT based on the operation packet OP.

In some example embodiments, the memory device 200 may receive the operation packet OP including plane order information regarding a subsequent plane. For example, data of the operation plane may be previously loaded into the second FIFO memory, and the input/output circuit 220 may output the data of the operation plane as the transmission data DT based on the operation packet OP. Thereafter, the input/output circuit 220 may load the data of the subsequent plane from the first FIFO memory corresponding to the subsequent plane to the second FIFO memory based on the plane order information of the operation packet OP.

The memory system 10 according to some inventive concepts may store the data read from the plurality of planes PL1 to PLk in registers (for example, the plurality of first FIFO memories) of the input/output circuit 220 respectively corresponding to the plurality of planes PL1 to PLk, based on one initial command-address. Accordingly, during a sequential read operation, the command-address CA corresponding to each of the plurality of planes PL1 to PLk may not be received, and because the data of the plurality of planes PL1 to PLk are stored at once in the registers of the input/output circuit 220 respectively corresponding to the plurality of planes PL1 to PLk, a delay time may be reduced, and thus, input/output efficiency may be further improved.

In addition, the memory system 10 according to some inventive concepts may load at least some pieces of the data of the plurality of planes PL1 to PLk into the input/output circuit 220 based on the operation packets OP including the plane order information, and accordingly, even when the command-addresses CA respectively corresponding to the plurality of planes PL1 to PLk are not received, the order of the plurality of planes PL1 to PLk from which data is output may be known, and the data of the plurality of planes PL1 to PLk may be output in a plane order. The delay time caused by transmitting and receiving the command-addresses CA respectively corresponding to the plurality of planes PL1 to PLk may be reduced, and thus, the input/output efficiency may be further improved.

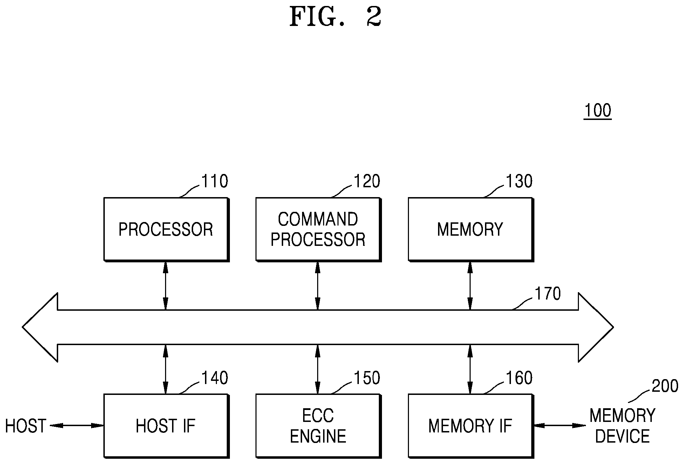

FIG. 2 is a block diagram illustrating a memory controller according to some example embodiments. A memory controller 100 of FIG. 2 corresponds to the memory controller 100 of FIG. 1, and accordingly, redundant descriptions thereof are omitted. Hereinafter, FIG. 1 and FIG. 2 are referred to together.

Referring to FIG. 1 and FIG. 2, the memory controller 100 may include a processor 110, a command processor 120, a memory 130, a host interface 140, an error correction code (ECC) engine 150, and a memory interface 160. The memory controller 100 may further include other components as needed. For example, the components of the memory controller 100 may communicate with each other through a bus 170.

The processor 110 may include a central processing unit (CPU) or a microprocessor and may control all operations of the memory controller 100. In some example embodiments, the processor 110 may be implemented by a multi-core processor, for example, a dual core processor or a quad core processor. For example, the processor 110 may execute instruction codes of firmware stored in the memory 130.

The command processor 120 may generate an initial command-address and transmit the initial command-address to the memory device 200. The initial command-address may instruct that the data stored in the plurality of planes PL1 to PLk included in one memory chip are stored in a memory of the input/output circuit 220.

The command processor 120 may generate the operation packets OP. The command processor 120 may generate the operation packets OP respectively corresponding to the plurality of planes PL1 to PLk included in one memory chip. The command processor 120 may generate the operation packets OP for controlling the memory device 200 such that data of operation planes are output from the input/output circuit 220 in which the data read from the operation planes are stored.

The command processor 120 may transmit the initial command-address to the memory device 200 and then transmit the operation packets OP to the memory device 200. The memory controller 100 may transmit the initial command-address to the memory device and sequentially transmit the operation packets OP in a plane order. In some example embodiments, the command processor 120 may add plane order information to the operation packets OP.

According to some example embodiments, the command processor 120 may be implemented by software, firmware, and/or hardware. In some example embodiments, the command processor 120 may be implemented by software, the memory controller 100 may further include a working memory into which the command processor 120 is loaded and may control an operation of generating the initial command-address and operation packets as the processor 110 operates the command processor 120, and transmitting the initial command-address and operation packets to the memory device 200. For example, the working memory may be implemented by a volatile memory, such as static random access memory (SRAM) or dynamic random access memory (DRAM), or a nonvolatile memory, such as flash memory or phase-change random access memory (PRAM).

The memory 130 may be used as an operating memory, a buffer memory, a cache memory, or so on, and may be implemented by, for example, DRAM, SRAM, PRAM, or flash memory. When the memory 130 is used as a buffer memory, the memory 130 may temporarily store data to be written to the memory device 200 or data to be read from the memory device 200. The memory 130 may be included in the memory controller 100 but may also be provided outside the memory controller 100. For example, the memory controller 100 may further include a buffer memory manager or a buffer memory interface for communicating with the memory 130.

The host interface 140 may communicate with a host. A command from the host or data to be written to the memory device 200 may be transmitted to the host interface 140. A response to a command from the host interface 140 or data read from the memory device 200 may be transmitted to the host via the host interface 140.

The ECC engine 150 may perform an error detection and correction function of the data output from the memory device 200. More specifically, the ECC engine 150 may generate parity bits for data to be provided to the memory device 200, and the generated parity bits may be stored in the memory device 200 together with the data provided to the memory device 200. When outputting data from the memory device 200, the ECC engine 150 may correct an error in the output data by using the parity bits output from the memory device 200 together with the output data and output the output data in which the error is corrected.

The memory interface 160 may provide an interface between the memory controller 100 and the memory device 200. For example, the transmission data DT and command-address CA may be transmitted and received between the memory controller 100 and the memory device 200 through the memory interface 160.

The bus 170 may operate based on one of various bus protocols. The various bus protocols may include at least one of an advanced microcontroller bus architecture (AMBA) protocol, a universal serial bus (USB) protocol, a multimedia card (MMC) protocol, a peripheral component interconnect (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a mobile industry processor interface (MIPI) protocol, a universal flash storage (UFS) protocol, and so on.

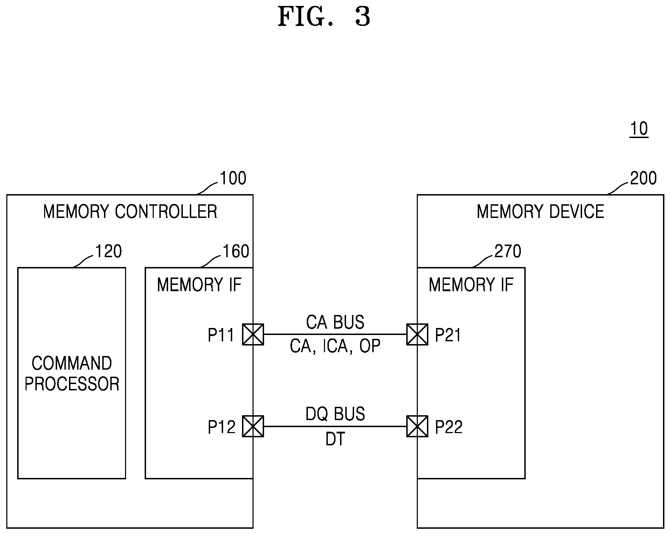

FIG. 3 is a diagram illustrating a memory system according to some example embodiments. Specifically, FIG. 3 is a diagram illustrating a SCA protocol. A memory system 10, a memory controller 100, and a memory device 200 of FIG. 3 respectively correspond to the memory system 10, the memory controller 100, and the memory device 200 of FIG. 1, and a command processor 120 of FIG. 3 corresponds to the command processor 120 of FIG. 2, and accordingly, redundant descriptions thereof are omitted.

Referring to FIG. 3, the memory system 10 includes the memory controller 100 and the memory device 200, and the memory device 200 may communicate with the memory controller 100 through buses. The memory controller 100 may transmit a command-address CA and transmission data DT to the memory device 200 through different buses.

The memory controller 100 may include the command processor 120 and a memory interface (I/F) 160. The command processor 120 may generate the command-address CA. In addition, the command processor 120 may generate an operation packet OP. The memory interface 160 may transmit the command-address CA to the memory device 200. The memory interface 160 may transmit data to be written to the memory device 200 as the transmission data DT, or receive data output from the memory device 200 as the transmission data DT. The memory interface 160 may be implemented to comply with a standard protocol, such as Toggle or ONFI.

The memory controller 100 may transmit the command-address CA to the memory device 200 through the bus. For example, the memory controller 100 may provide the command-address CA to the memory device 200 through a command-address bus (hereinafter, a CA bus). The memory controller 100 may transmit and receive the transmission data DT to and from the memory device 200 through a data bus (hereinafter, a DQ bus). For example, the memory controller 100 may receive the transmission data DT from the memory device 200 through the DQ bus during a read operation.

The memory controller 100 may include a first pin P11 and a second pin P12. The memory device 200 may include a first pin P21 and a second pin P22. The first pin P11 and the second pin P12 may respectively correspond to the first pin P21 and the second pin P22. The first pin P11 and the first pin P21 may be connected to a CA bus, and the second pin P12 and the second pin P22 may be connected to a DQ bus. The memory controller 100 and the memory device 200 may transmit and receive signals through the first pin P11 and the second pin P12 and the first pin P21 and the second pin P22. Although FIG. 3 illustrates that each of the memory controller 100 and the memory device 200 includes two pins, this is only for the sake of convenience of description, and the inventive concepts are not necessarily limited thereto. For example, the memory system 10 may further include buses and pins for transmitting a chip enable signal CE/, a command latch enable signal CLE, an address latch enable signal ALE, and so on.

The memory interface 160 may transmit an initial command-address ICA to the memory device 200 through a CA bus. For example, the memory interface 160 may transmit the initial command-address ICA to the memory device 200 through the first pin P11.

The memory interface 160 may transmit an operation packet OP to the memory device 200. For example, the memory interface 160 may transmit the operation packet OP through the CA bus. The memory interface 160 may transmit the operation packet OP to the memory device 200 through the first pin P11.

In addition, the memory interface 160 may transmit and receive transmission data DT to and from the memory device 200 through a DQ bus. The memory interface 160 may transmit the transmission data DT to the memory device 200 through the second pin P12 or receive the transmission data DT from the memory device 200. During a read operation, the memory interface 160 may receive the transmission data DT from the memory device 200 through the second pin P12.

The memory device 200 may include a memory interface (I/O) 270. A command-address CA may be transmitted to the memory device 200 through the CA bus. The memory interface 270 may receive the initial command-address ICA from the memory controller 100 through the first pin P21. In addition, the memory interface 270 may receive the operation packet OP from the memory controller 100 through the first pin P21.

In addition, the memory interface 270 may transmit the transmission data DT to the memory controller 100 through the second pin P22 or receive the transmission data DT from the memory controller 100. For example, during a read operation, the transmission data DT may be output from the second pin P22 based on the operation packet OP received through the first pin P21.

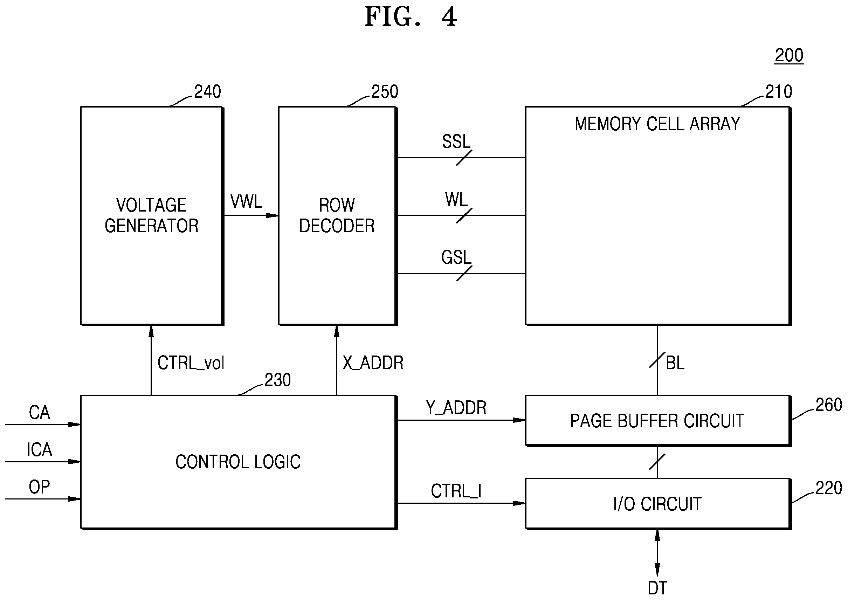

FIG. 4 is a diagram illustrating a memory device according to some example embodiments. Redundant descriptions of the memory device are omitted.

Referring to FIG. 4, a memory device 200 may include a memory cell array 210, a control logic 230, a voltage generator 240, a row decoder 250, a page buffer circuit 260, and an input/output (I/O) circuit 220.

The memory cell array 210 may include a plurality of memory cells and may be connected to word lines WL, string selection lines SSL, ground selection lines GSL, and a plurality of bit lines BL. Specifically, the memory cell array 210 may be connected to the row decoder 250 through the word lines WL, the string selection lines SSL, and the ground selection lines GSL and may be connected to the page buffer circuit 260 through the plurality of bit lines BL.

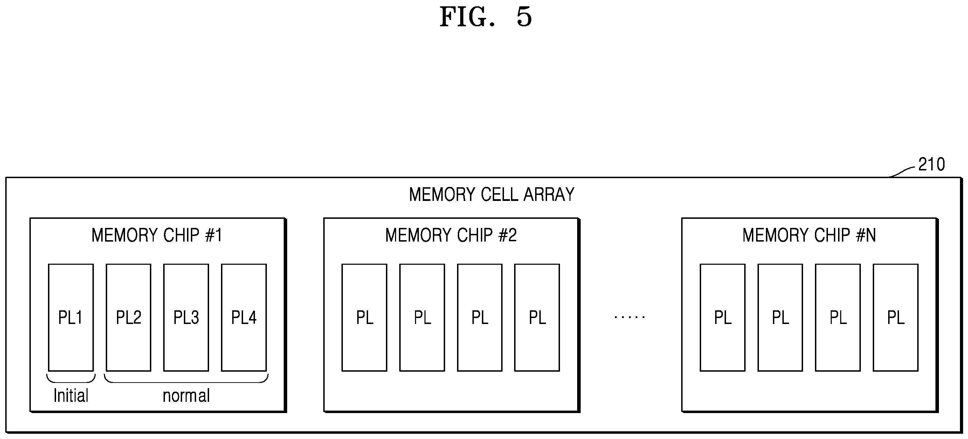

The memory cell array 210 may include a plurality of memory blocks, and for example, each of the plurality of memory blocks may include a plurality of memory cells. The plurality of memory blocks may be selected by the row decoder 250. For example, the row decoder 250 may select a memory block corresponding to a block address from among the plurality of memory blocks. The memory cell array 210 is described below in detail with reference to FIG. 5.

The control logic 230 may generally control various operations of the memory device 200. For example, the control logic 230 may output various control signals for writing data to the memory cell array 210 or reading data from the memory cell array 210 based on the command-address CA. For example, the control logic 230 may output a voltage control signal CTRL_vol, a row address X_ADDR, a column address Y_ADDR, and an input/output control signal CTRL_I. The various control signals output from the control logic 230 may be provided to components of the memory device 200. For example, the various control signals output from the control logic 230 may be provided to the voltage generator 240, the row decoder 250, the page buffer circuit 260, and the input/output circuit 220. The control logic 230 may provide the voltage control signal CTRL_vol to the voltage generator 240, the row address X_ADDR to the row decoder 250, the column address Y_ADDR to the page buffer circuit 260, and the input/output control signal CTRL_I to the input/output circuit 220.

The control logic 230 may receive an initial command-address ICA. For example, the control logic 230 may receive the initial command-address ICA through a command-address bus (for example, the CA bus of FIG. 3). The initial command-address ICA may be a command-address for instructing a memory operation for a plurality of planes included in one memory chip of the memory cell array 210. The control logic 230 may control the input/output circuit 220 such that data stored in the plurality of planes included in one memory chip are temporarily stored in the input/output circuit 220 based on the initial command-address ICA.

The control logic 230 may receive an operation packet OP. For example, the control logic 230 may receive the operation packet OP through the command-address bus. The operation packet OP may indicate a packet for instructing the data stored in an operation plane corresponding to the operation packet OP to be output from the memory device 200. The control logic 230 may control the input/output circuit 220 based on the operation packet OP such that data of the operation plane is read and output as transmission data DQ. For example, the control logic 230 may control the input/output circuit 220 based on the operation packet OP such that the data of the operation plane loaded in a second FIFO memory (for example, the second FIFO memory FIFO2 of FIG. 6) is output to a memory controller (for example, the memory controller 100 of FIG. 1). The control logic 230 may generate the input/output control signal CTRL_I to control the input/output circuit 220. The control logic 230 may generate the input/output control signal CTRL_I based on the initial command-address ICA and the operation packets OP.

In some example embodiments, the operation packet OP may include plane order information. The control logic 230 may cause at least some of the data of a plurality of planes of the memory cell array 210 to be loaded into the input/output circuit 220 based on the plane order information.

The voltage generator 240 may generate various types of voltages for performing a write operation, a read operation, and an erase operation of the memory cell array 210 in response to the voltage control signal CTRL_vol. Specifically, the voltage generator 240 may generate a word line voltage VWL, for example, a write voltage, a read voltage, an erase voltage, or so on. For example, during a read operation, the voltage generator 240 may generate a read voltage under the control of the control logic 230 and provide the read voltage to the row decoder 250. In addition, the voltage generator 240 may further generate a string selection line voltage and a ground selection line voltage in response to the voltage control signal CTRL_vol.

The row decoder 250 may select a certain word line from among the word lines WL based on the row address X_ADDR received from the control logic 230. For example, during the read operation, the row decoder 250 may provide a read voltage to the selected word line. In addition, the row decoder 250 may select some string selection lines from among the string selection lines SSL or some ground selection lines from among the ground selection lines GSL based on the row address X_ADDR received from the control logic 230.

The page buffer circuit 260 may be connected to the memory cell array 210 through a plurality of bit lines (BL). The page buffer circuit 260 may select at least some of the plurality of bit lines BL based on the column address Y_ADDR received from the control logic 230. The page buffer circuit 260 may temporarily store the data read from the memory cell array 210. The page buffer circuit 260 may dump the data stored in the page buffer circuit 260 to the input/output circuit 220 under the control of the control logic 230.

The page buffer circuit 260 may include a plurality of page buffers respectively connected to a plurality of bit lines BL. The plurality of page buffers may be arranged to correspond to the plurality of bit line BL, and the plurality of page buffers may each include a plurality of latches. The page buffer circuit 260 may be defined as including the plurality of page buffers respectively connected to the plurality of bit lines BL. However, some example embodiments may define terms differently, and for example, page buffers may be provided to respectively correspond to multiple bit lines, and units of configuration arranged to respectively correspond to the multiple bit lines may also be defined as page buffer units.

The input/output circuit 220 may include a plurality of registers. For example, the input/output circuit 220 may include a plurality of first registers respectively corresponding to a plurality of planes, and a second register into which at least some pieces of the data stored in the plurality of first registers are loaded. For example, the plurality of first registers may be a plurality of first FIFO memories, and the second register may be a second FIFO memory, but the embodiments are not limited thereto. The first FIFO memory and the second FIFO memory are described below in detail with reference to FIG. 6.

The input/output circuit 220 may store data in the registers of the input/output circuit 220. The input/output circuit 220 may temporarily store transmission data DT provided from the outside of the memory device 200. The input/output circuit 220 may temporarily store the data read from the memory device 200 and output the data to the outside of the memory device 200 as the transmission data DT. For example, the input/output circuit 220 may temporarily store the data read from the memory device 200 and output the transmission data DT to the outside at a designated time. In some example embodiments, the input/output circuit 220 may be connected to a data bus (a DQ bus). For example, the input/output circuit 220 may output the transmission data DT to the outside of the memory device 200 through the DQ bus, or receive the transmission data DT provided from the outside of the memory device 200 through the DQ bus.

The input/output circuit 220 may be controlled by the control logic 230. The input/output circuit 220 may operate in response to the input/output control signal CTRL_I received from the control logic 230. For example, the input/output circuit 220 may perform a memory operation for a plurality of planes in response to the input/output control signal CTRL_I generated based on the initial command-address ICA. For example, the input/output circuit 220 may receive the data stored in the plurality of planes and store the data in the plurality of first registers respectively corresponding to the plurality of planes based on the initial command-address ICA. That is, the input/output circuit 220 may receive the data from the plurality of planes and store the data in the plurality of first registers respectively corresponding to the plurality of planes based on the initial command-address ICA.

The input/output circuit 220 may output data in response to the input/output control signal CTRL_I generated based on the operation packet OP. The input/output circuit 220 may output data of the operation plane based on the operation packet OP. The input/output circuit 220 may output the data of the operation plane among the data read from the plurality of planes included in the input/output circuit 220 based on the operation packet OP. For example, the data of the operation plane may be loaded into the second register from the plurality of first registers in which the data read from the plurality of planes are stored, and the input/output circuit 220 may output the data of the operation plane loaded in the second register based on the operation packet OP as the transmission data DT.

The input/output circuit 220 may load at least some pieces of the data of the plurality of planes into the input/output circuit 220 based on the plane order information included in the operation packet OP. For example, the input/output circuit 220 may select data to be loaded into the second register from among the data stored in the plurality of first registers based on the plane order information.

FIG. 5 is a diagram illustrating a memory cell array 210 according to some example embodiments. Redundant description of the memory cell array 210 is omitted.

Referring to FIG. 5, the memory cell array 210 may include a plurality of memory chips. The memory cell array 210 may include N (N is a positive number of 2 or more) memory chips. However, the inventive concept is not limited thereto, and the memory cell array 210 may include one memory chip. The respective memory chips may each include a plurality of planes PL. One plane PL may include a plurality of memory blocks, and one memory block may include a plurality of memory cells. Although FIG. 5 illustrates that one memory chip includes four planes PL, this is only an example, and the one memory chip may include a variety of planes PL.

Data stored in the plurality of planes PL included in one memory chip may be read based on an initial command-address (for example, the initial command-address ICA of FIG. 4). For example, based on a first initial command-address, data read from each of the first plane PL1 to the fourth plane (PL4) may be loaded into an input/output circuit (e.g., the input/output circuit 220 of FIG. 4). For example, based on a second initial command-address, the data read from the plurality of planes PL included in a second memory chip may be loaded into an input/output circuit.

For example, a first memory chip includes a first plane PL1, a second plane PL2, a third plane PL3, and a fourth plane PL4, and it is assumed that a plane order is sequential from the first plane PL1 to the fourth plane PL4. The plane order may mean the order in which the data stored in the plurality of planes PL included in one memory chip is output to a memory controller (for example, the memory controller 100 of FIG. 4). According to the plane order, the data stored in the plurality of planes PL may be output to the outside. For example, data of the first plane PL1 may be output first, and data of the second plane PL2, data of the third plane PL3, and data of the fourth plane PL4 may be output sequentially.

The plurality of planes PL included in one memory chip may each include an initial plane and normal planes. The initial plane may refer to a plane from which data is output first from one memory chip. Among the plurality of planes PL included in one memory chip, data of the initial plane may be output first to the outside of the memory device. For example, data of the first plane PL1 may be output first from the first memory chip, and the initial plane of the first memory chip may be the first plane PL1.

The normal planes may mean planes where data is output from one memory chip after the initial plane. After the data of the initial plane is output, the data of the normal planes may be output. For example, the second plane PL2, the third plane PL3, and the fourth plane PL4 included in the first memory chip may correspond to the normal planes.

FIG. 6 is a diagram illustrating an input/output circuit according to some example embodiments. FIG. 6 illustrates some components of the memory device 200 for the sake of convenience of description.

Referring to FIG. 6, the memory device 200 may include a memory cell array 210, a control logic 230, a page buffer circuit 260, and an input/output circuit 220. The memory cell array 210 may include k planes PL. FIG. 6 illustrates that the memory device 200 includes one memory chip for the sake of convenience of description, but it should be understood that the memory device 200 may include a plurality of memory chips. Hereinafter, it is assumed that a plurality of planes PL indicates multiple planes PL included in the same memory chip.

The page buffer circuit 260 may be connected to the memory cell array 210 through a plurality of bit lines. The page buffer circuit 260 may include a plurality of page buffers PB1 to PBk. For example, the page buffer circuit 260 may include the plurality of page buffers PB respectively corresponding to the plurality of planes PL. The page buffer circuit 260 may include k page buffers PB1 to PBk. For example, a first page buffer PB1 may correspond to a first plane PL1, a second page buffer PB2 may correspond to a second plane PL2, a k-1^{th} page buffer PBk-1 may correspond to a k-1^{th} plane PLk-1, and a k^{th} page buffer PBk may correspond to a k^{th} plane PLk. The plurality of page buffers PB may be respectively connected to the plurality of planes PL.

The page buffer circuit 260 may temporarily store the data read from the memory cell array 210. The plurality of page buffers PB may respectively and temporarily store the data read from the plurality of planes PL. For example, the first page buffer PB1 may load the data read from the first plane PL1, the second page buffer PB2 may load the data read from the second plane PL2, the k-1^{th} page buffer PBk-1 may load the data read from the k-1^{th} plane PLk-1, and the k^{th} page buffer PBk may load the data read from the k^{th} plane PLk.

The input/output circuit 220 may receive and temporarily store the data loaded in the plurality of page buffers PB. The input/output circuit 220 may include a plurality of registers. The input/output circuit 220 may include a first FIFO circuit 221 and a second FIFO memory FIFO2. The first FIFO circuit 221 may include a plurality of first FIFO memories FIFO1. For example, the first FIFO circuit 221 may include the first FIFO memories FIFO1 respectively corresponding to the plurality of planes PL. The first FIFO circuit 221 may include k first FIFO memories FIFO1_1 to FIFO1_k. For example, the first FIFO memory FIFO1_1 may correspond to the first plane PL1, the first FIFO memory FIFO1_2 may correspond to the second plane PL2, the first FIFO memory FIFO1_k-1 may correspond to the k-1^{th} plane PLk-1, and the first FIFO memory FIFO1_k may correspond to the k^{th} plane PLk.

The first FIFO circuit 221 may temporarily store the data read from the memory cell array 210. The first FIFO circuit 221 may temporarily store the data loaded in the page buffer circuit 260. The plurality of first FIFO memories FIFO1 may respectively and temporarily store the data read from the plurality of planes PL. For example, the first FIFO memory FIFO1_1 may load the data of the first plane PL1 received from the first page buffer PB1, the first FIFO memory FIFO1_2 may load the data of the second plane PL2 received from the second page buffer PB2, and the first FIFO memory FIFO1_k may load the data of the k^{th} plane PLk received from the k^{th} page buffer PBk.

In some example embodiments, the memory device 200 may perform a multi-plane read operation (or a sequential read operation) for reading data from at least two planes among the plurality of planes PL1 to PLk. The memory device 200 may perform the multi-plane read operation under the control of the control logic 230. The first FIFO circuit 221 may operate in response to an input/output control signal CTRL_I generated based on the initial command-address (ICA).

In some example embodiments, the first FIFO circuit 221 may store the data read from the plurality of planes PL in the plurality of first FIFO memories FIFO1 respectively corresponding to the plurality of planes PL based on the initial command-address ICA. The first FIFO circuit 221 may temporarily receive and store the data read from the plurality of planes PL and loaded in the page buffer circuit 260 based on the initial command-address ICA. The plurality of first FIFO memories FIFO1 may respectively receive and store the data stored in the plurality of page buffers PB at once based on the initial command-address ICA. For example, the first FIFO memories FIFO1_1 to FIFO1_k may respectively and temporarily store the data of the first plane PL1 to the data of the k^{th} plane PLk respectively stored in the first page buffer PB1 to the k^{th} page buffer PBk based on the initial command-address ICA.

The memory device 200 according to the inventive concepts may store the data of the plurality of planes PL1 to PLk at once in the plurality of first FIFO memories FIFO1 respectively corresponding to the plurality of planes PL1 to PLk based on the initial command-address ICA, and accordingly, command-addresses respectively corresponding to the plurality of planes PL1 to PLk may not be received, and a delay time may be reduced to further improve the I/O efficiency.

The second FIFO memory FIFO2 may load at least some pieces of the data stored in the first FIFO circuit 221. The second FIFO memory FIFO2 may load the data stored in the first FIFO circuit 221 under the control of the control logic 230. The second FIFO memory FIFO2 may load the data stored in one of the first FIFO memories FIFO1. For example, the second FIFO memory FIFO2 may load the data of the first plane PL1 stored in the first FIFO memory FIFO1_1. The second FIFO memory FIFO2 may output the data loaded in the second FIFO memory FIFO2 as the transmission data DT. For example, the data of the first plane PL1 loaded in the second FIFO memory FIFO2 may be output to the outside of the memory device 200 as the transmission data DT.

The second FIFO memory FIFO2 may output the data in response to an input/output control signal CTRL_I generated based on the operation packet OP. The second FIFO memory FIFO2 may output data of an operation plane loaded in the second FIFO memory FIFO2 based on the operation packet OP. The second FIFO memory FIFO2 may output the data of the operation plane loaded in the second FIFO memory FIFO2 as the transmission data DT based on the operation packet OP.

Although FIG. 6 illustrates that the first FIFO circuit 221 and the second FIFO memory FIFO2 are included in the input/output circuit 220, the inventive concepts are not limited thereto, and at least one of the first FIFO circuit 221 and the second FIFO memory FIFO2 may be arranged outside the input/output circuit 220.

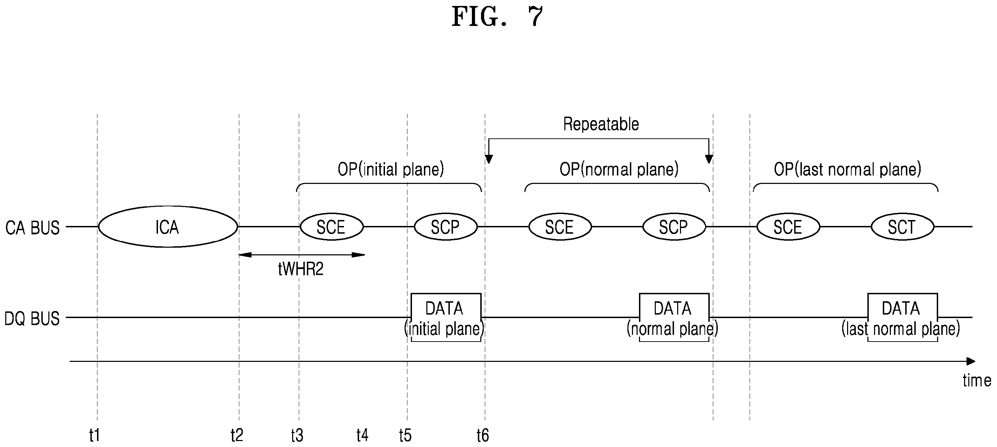

FIG. 7 is a timing diagram illustrating an initial command-address and operation packets according to some example embodiments. FIG. 7 illustrates a multi-plane read operation for a plurality of planes included in one memory chip. In FIG. 7, a horizontal axis represents time. Redundant description the multi-plane read operation are omitted. Hereinafter, FIG. 1 and FIG. 6 are referred to together.

Referring to FIG. 1, FIG. 6, and FIG. 7, at a first time point t1, an initial command-address ICA may be provided to the memory device 200 through a CA bus. At a second time point t2, the memory device 200 may store, in the input/output circuit 220, the data read from the plurality of planes PL based on the initial command-address ICA. At a time period tWHR2 between the second time point t2 and a fourth time point t4, the memory device 200 may store the data read from the plurality of planes PL in the plurality of first FIFO memories FIFO1 respectively corresponding to the plurality of planes PL based on the initial command-address ICA. For example, the first FIFO memory FIFO1_1 to the first FIFO memory FIFO1_k may respectively load data of the first plane PL1 to data of the k^{th} plane PLk respectively stored in the first page buffer PB1 to the k^{th} page buffer PBk based on the initial command-address ICA.

After the initial command-address ICA is transmitted, the operation packets OP may be provided to the memory device 200 through the CA bus from a third time point t3. The operation packets OP respectively corresponding to the plurality of planes PL may be provided to the memory device 200. Based on the operation packets OP, data of operation planes respectively corresponding to the operation packets OP may be output. The second FIFO memory FIFO2 may output the data of the operation planes loaded in the second FIFO memory FIFO2 based on the operation packets OP.

The operation packets OP may be sequentially provided to the memory device 200 according to a plane order. After the initial command-address ICA is transmitted, an operation packet OP corresponding to an initial plane, which is the first in the plane order, may be provided to the memory device 200. At the third time point t3, the operation packet OP corresponding to the initial plane may be provided to the memory device 200.

The memory device 200 may output the data to the outside of the memory device 200 based on the operation packet OP. The memory device 200 may output data DATA of the initial plane based on the operation packet OP corresponding to the initial plane. The second FIFO memory FIFO2 may output the data DATA of the initial plane loaded in the second FIFO memory FIFO2 based on the operation packet OP corresponding to the initial plane. For example, the data DATA of the initial plane may be provided to the memory controller 100 through the DQ bus from a fifth time point t5. The data DATA of the initial plane may be output as the transmission data DT from the second FIFO memory FIFO2.

After the operation packet OP corresponding to the initial plane is transmitted, operation packets OP respectively corresponding to normal planes may be transmitted in the plane order. The operation packets respectively corresponding to the normal planes may be repeatedly transmitted in the plane order. The second FIFO memory FIFO2 may output the data DATA of the normal planes loaded in the second FIFO memory FIFO2 based on the operation packets OP respectively corresponding to the normal planes. The data DATA of the normal planes may be output to the memory controller 100 through the DQ bus.

An operation packet OP corresponding to the last normal plane may be transmitted according to the plane order. The memory device 200 may receive the operation packets OP respectively corresponding to the normal planes in the plane order until the memory device 200 receives the operation packet OP respectively corresponding to the last normal plane. The last normal plane may refer to the normal plane of which plane order is the last. The second FIFO memory FIFO2 may output the data DATA of the last normal plane loaded in the second FIFO memory FIFO2 based on the operation packet OP corresponding to the last normal plane.

The operation packets OP may include an operation execution packet SCE and operation completion packets SCP and SCT. The operation execution packet SCE may refer to a packet that instructs to output the data stored in the operation plane corresponding to the operation packet OP. The operation execution packet SCE may instruct to output the data of the operation plane loaded in the second FIFO memory FIFO2.

The operation completion packets SCP and SCT may refer to packets that indicate an output completion of the data stored in the operation plane. The operation completion packets SCP and SCT may indicate the output completion of the data of the operation plane loaded in the second FIFO memory FIFO2. For example, the operation completion packet SCT corresponding to the last normal plane may be different from the operation completion packets SCP corresponding to the other planes.

For example, at the third time point t3, the operation execution packet SCE corresponding to the initial plane may be provided to the memory device 200 through the CA bus. The second FIFO memory FIFO2 may output the data DATA of the initial plane loaded in the second FIFO memory FIFO2 based on the operation execution packet SCE corresponding to the initial plane. The operation completion packet SCP corresponding to the initial plane may be provided to the memory device 200 through the CA bus. The memory device 200 may output the data DATA of the initial plane from the fifth time point t5 to a sixth time point t6. When the data of an operation plane is transmitted to the memory controller 100, the operation completion packet SCP may also be transmitted to the memory device 200. However, the inventive concepts are not limited thereto, and when the data of the operation plane is completely transmitted to the memory controller 100, the memory device 200 may also receive the operation completion packet SCP.

The operation execution packet SCE of the normal plane may be provided to the memory device 200 through the CA bus. The second FIFO memory FIFO2 may output the data DATA of the normal plane loaded in the second FIFO memory FIFO2 based on the operation execution packets SCE corresponding to the normal planes. When the data DATA of the normal plane is transmitted to the memory controller 100, the operation completion packet SCP may also be transmitted to the memory device 200. In addition, when the data DATA of the last normal plane are transmitted to the memory controller 100, the operation completion packet SCT may also be transmitted to the memory device 200.

The operation packet OP may include plane order information. The memory device 200 may load at least some pieces of the data of the plurality of planes PL to the input/output circuit 220 based on the plane order information. The memory device 200 may switch the planes based on the plane order information and load the data of the switched planes into the second FIFO memory FIFO2. For example, data to be loaded into the second FIFO memory FIFO2 may be selected from among the data stored in the plurality of first FIFO memories FIFO1 based on the plane order information.

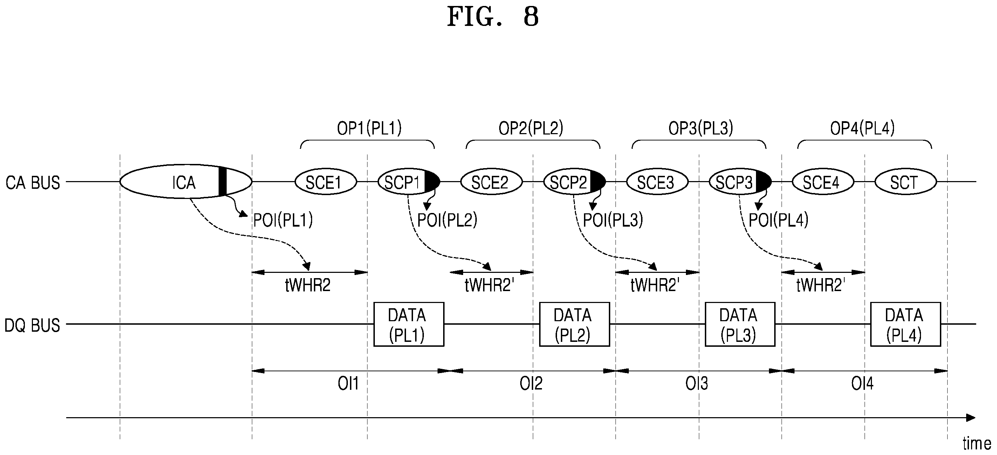

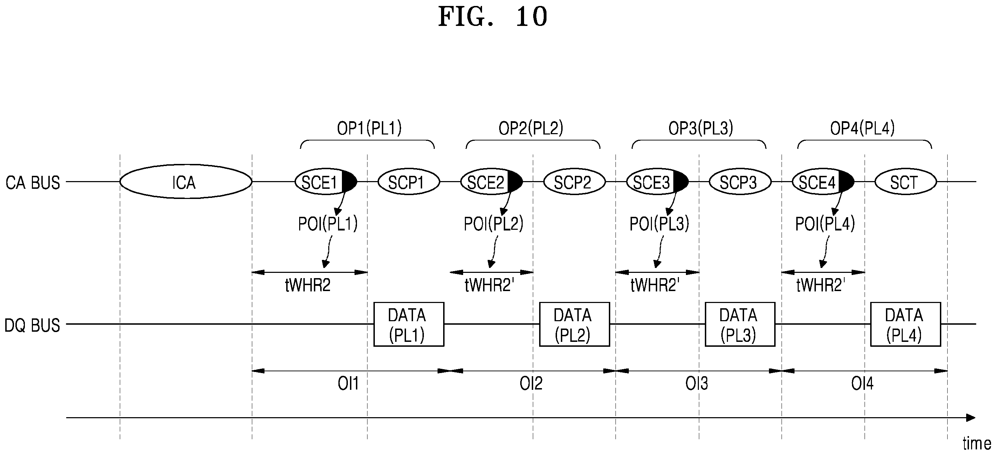

In some example embodiments, the operation completion packet SCP may include the plane order information. For example, the operation completion packet SCP may include the plane order information regarding a subsequent plane. Some example embodiments in which the operation completion packet SCP includes the plane order information is described below in detail with reference to FIG. 8. In some example embodiments, the operation execution packet SCE may include the plane order information. For example, the operation execution packet SCE may include the plane order information regarding an operation plane. In some example embodiments in which the operation execution packet SCE includes the plane order information is described below in detail with reference to FIG. 10.

The memory device according to some example embodiments may receive only the initial command-address ICA and the operation packets respectively corresponding to the plurality of planes PL without receiving command-addresses respectively corresponding to the plurality of planes PL. Because the command-addresses respectively corresponding to the plurality of planes PL are not received, a delay time occurring when transmitting and receiving the command-addresses respectively corresponding to the plurality of planes PL is reduced, and thus, the I/O efficiency may be improved. In addition, the memory device according to some example embodiments may perform a multi-plane read operation (or a sequential read operation) by switching planes based on at least one of the initial command-address ICA and the operation packets OP respectively corresponding to the plurality of planes PL.

FIG. 8 is a timing diagram illustrating an embodiment in which the operation completion packet SCP includes plane order information, according to some example embodiments. In FIG. 8, it is assumed that a memory includes a first plane PL1, a second plane PL2, a third plane PL3, and a fourth plane PL4, and a plane order is sequential from the first plane PL1 to the fourth plane PL4. The initial plane may be the first plane PL1, the normal planes may include the second plane PL2 to the fourth plane PL4, and the fourth plane PL4 may be the last normal plane. Redundant descriptions of the planes are omitted below.

The operation packets OP may respectively correspond to the plurality of planes PL. A first operation packet OP1 may correspond to the first plane PL1 and include a first operation execution packet SCE1 and a first operation completion packet SCP1. A second operation packet OP2 may correspond to the second plane PL2 and include a second operation execution packet SCE2 and a second operation completion packet SCP2. A third operation packet OP3 may correspond to the third plane PL3 and include a third operation execution packet SCE3 and a third operation completion packet SCP3. A fourth operation packet OP4 may correspond to the fourth plane PL4 and include a fourth operation execution packet SCE4 and a fourth operation completion packet SCP4.

The initial command-address ICA may include plane order information POI on the initial plane. For example, the initial command-address ICA may include the plane order information POI on the first plane PL1.

The operation packets OP may include the plane order information. The operation completion packet SCP may include the plane order information POI. In some example embodiments, the operation completion packet SCP may include the plane order information POI on a subsequent plane. For example, the subsequent plane of the first plane PL1 may be the second plane PL2, and the first operation completion packet SCP1 may include the plane order information POI on the second plane PL2. A subsequent plane of the second plane PL2 may be the third plane PL3, and the second operation completion packet SCP2 may include the plane order information POI on the third plane PL3. A subsequent plane of the third plane PL3 may be the fourth plane PL4, and the third operation completion packet SCP3 may include the plane order information POI on the fourth plane PL4. Because the fourth operation completion packet SCT may correspond to the last normal plane, the fourth operation completion packet SCT may not include the plane order information POI.

Data of the operation plane may be output in operation periods OI. For example, the data DATA of the first plane PL1, which is the operation plane, may be output in a first operation period OI1. The first operation period OI1 may include a first waiting time period tWHR2, and the memory device may perform an operation based on the initial command-address ICA in the first waiting time period tWHR2. The memory device may perform an operation based on the plane order information POI included in the initial command-address ICA in the first waiting time period tWHR2. After the first waiting time period tWHR2, data of the first plane PL1 may be output based on the first operation packet OP1.

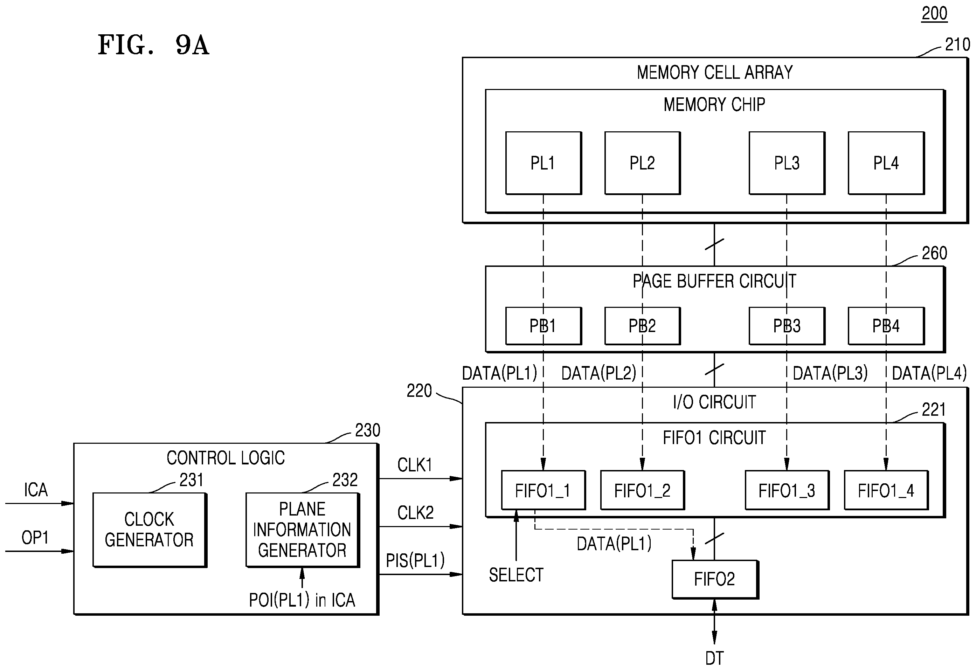

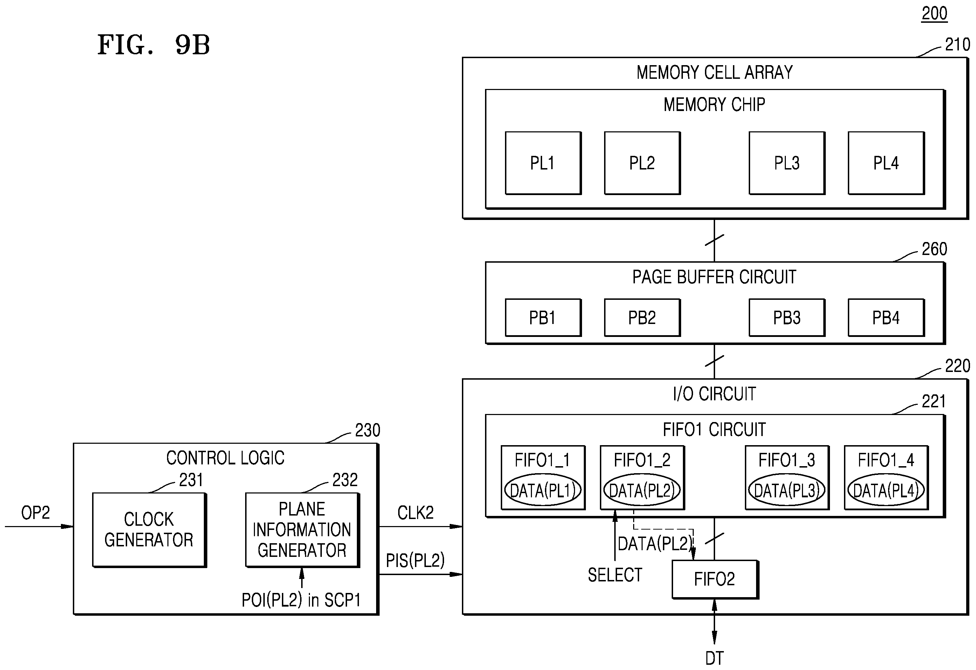

In a second operation period OI2, data of the second plane PL2, which is an operation plane, may be output. The second operation period OI2 may include a second waiting time period tWHR2', and the memory device may perform an operation based on the plane order information POI included in the operation packet OP corresponding to a preceding plane in the second waiting time period tWHR2'. For example, the memory device may perform an operation based on the plane order information POI on the second plane PL2 included in the first operation completion packet SCP1. After the second waiting time period tWHR2' of the second operation period OI2, the data DATA of the second plane PL2 may be output based on the second operation packet OP2. The memory device may perform an operation similar to the second operation period OI2 in a third operation period OI3 and a fourth operation period OI4. Hereinafter, the operation of the memory device 200 is described in detail with reference to FIGS. 9A and 9B.

FIG. 9A is a diagram illustrating an operating method of a memory device 200 in the first operation period OI1 of FIG. 8. Hereinafter, FIG. 8 and FIG. 9A are referred to together.

Referring to FIG. 8 and FIG. 9A together, the memory device 200 may receive the initial command-address ICA. The memory device 200 may perform an operation indicated by the initial command-address ICA in the first waiting time period tWHR2. In the first waiting time period tWHR2, the memory device 200 may load the data DATA stored in the first plane PL1 to the fourth plane PL4 into the first FIFO circuit 221 based on the initial command-address ICA. The control logic 230 may generate an input/output control signal (for example, the input/output control signal CTRL_I of FIG. 6) for loading the data stored in the first plane PL1 to the fourth plane PL4 into the first FIFO circuit 221.

In some example embodiments, the control logic 230 may include a clock generator 231. The clock generator 231 may generate a clock signal for controlling the input/output circuit 220. For example, the clock signal may be included in the input/output control signal CTRL_I. The clock generator 231 may generate a first clock signal CLK1 for controlling the first FIFO memory FIFO1. The clock generator 231 may generate the first clock signal CLK1 based on the initial command-address ICA. In response to the first clock signal CLK1, the first FIFO memory FIFO1_1 may load the data DATA of the first plane PL1, the first FIFO memory FIFO1_2 may load the data DATA of the second plane PL2, the first FIFO memory FIFO1_3 may load the data DATA of the third plane PL3, and the first FIFO memory FIFO1_4 may load the data DATA of the fourth plane PL4.

The memory device 200 may switch a plane to the initial plane based on the initial command-address ICA. The memory device 200 may first load the data of the initial plane from the first FIFO memory FIFO1 to the second FIFO memory FIFO2 based on the initial command-address ICA. The data DATA loaded in the first FIFO memory FIFO1 may be loaded into the second FIFO memory FIFO2 to be output to the memory controller 100 in the plane order in which the data DATA is output. In the first waiting time period tWHR2, the memory device 200 may select data of the operation plane from among the data loaded in the first FIFO circuit 221 based on the initial command-address ICA and load the selected data into the second FIFO memory FIFO2. The data DATA read from the first plane PL1 to the fourth plane PL4 may be respectively loaded into the first FIFO memory FIFO1_1 to the first FIFO memory FIFO1_4 based on the initial command-address ICA, and then the data DATA of the operation plane may be loaded into the second FIFO memory FIFO2.

In some example embodiments, a plane information generator 232 may generate a plane selection signal PIS for selecting the initial plane based on the initial command-address ICA. The initial command-address ICA may include the plane order information POI of the initial plane. In some example embodiments, the control logic 230 may include the plane information generator 232. The plane information generator 232 may generate the plane selection signal PIS based on the plane order information. The plane selection signal PIS may refer to a signal for selecting data of a plane to be loaded into the second FIFO memory FIFO2. For example, the plane selection signal PIS may be included in the input/output control signal CTRL_I.

The plane information generator 232 may generate the plane selection signal PIS for the initial plane based on the plane order information POI included in the initial command-address ICA. For example, the plane information generator 232 may generate the plane selection signal PIS for selecting the first plane PL1. The input/output circuit 220 may select the first FIFO memory FIFO1_1 corresponding to the first plane PL1 in response to the plane selection signal PIS and load the data of the first plane PL1 from the first FIFO memory FIFO1_1 to the second FIFO memory FIFO2. In the first waiting time period tWHR2, data of the first plane PL1 may be loaded into the second FIFO memory FIFO2. For example, the plane order information POI may be an address indicating a plane but is not limited thereto.

The memory device 200 may receive a first operation packet OP1. The memory device 200 may perform an operation indicated by the first operation execution packet SCE1 in the first waiting time period tWHR2. In the first operation period OI1, the memory device 200 may output the data DATA loaded in the second FIFO memory FIFO2 to the outside of the memory device 200 as the transmission data DT based on the first operation execution packet SCE1. The control logic 230 may generate an input/output control signal CTRL_I for outputting the data DATA loaded in the second FIFO memory FIFO2.

In some example embodiments, the clock generator 231 may generate a second clock signal CLK2 for controlling the second FIFO memory FIFO2. The clock generator 231 may generate the second clock signal CLK2 based on the operation packet OP. For example, the clock generator 231 may generate the second clock signal CLK2 based on the first operation execution packet SCE1. In response to the second clock signal CLK2, the data DATA of the first plane PL1 loaded in the second FIFO memory FIFO2 may be output to a memory controller (for example, the memory controller 100 of FIG. 1) as the transmission data DT. In the first operation period OI1, the data DATA of the first plane PL1 may be output to the memory controller 100.

Although FIG. 9A illustrates that the control logic 230 includes the clock generator 231 and the plane information generator 232, the inventive concepts are not limited thereto, and at least one of the clock generator 231 and the plane information generator 232 may be a separate component from the control logic 230.

FIG. 9B is a diagram illustrating an operating method of the memory device 200 in the second operation period OI2 of FIG. 8. Hereinafter, FIG. 8 and FIG. 9B are referred to together.

The memory device 200 may switch normal planes based on the operation completion packet SCP. The memory device 200 may load data of a subsequent plane from the first FIFO memory FIFO1 corresponding to a subsequent plane into the second FIFO memory FIFO2 based on the plane order information POI included in the operation packet OP. In a subsequent operation period in which data of a subsequent plane is output, the input/output circuit 220 may select the data DATA of the subsequent plane from among the data DATA stored in the first FIFO circuit 221 based on the plane order information POI on the subsequent plane. For example, in the second operation period OI2, the input/output circuit 220 may select the data DATA of the second plane PL2 from among the data DATA loaded in the first FIFO circuit 221 based on the plane order information POI on the second plane PL2. The plane order information POI on the second plane PL2 may be included in the first operation packet OP1.

The memory device 200 may generate the plane selection signal PIS by using the preceding operation packet OP. In the second operation period OI2, the memory device 200 may generate the plane selection signal PIS based on the first operation packet OP1. The first operation completion packet SCP1 may include the plane order information POI on the second plane PL2 that follows.

The plane information generator 232 may generate the plane selection signal PIS based on the plane order information POI on the second plane PL2. For example, the plane information generator 232 may generate the plane selection signal PIS for selecting the second plane PL2 based on the plane order information POI on the second plane PL2 included in the first operation completion packet SCP1. The input/output circuit 220 may select the first FIFO memory FIFO1_2 corresponding to the second plane PL2 in response to the plane selection signal PIS, and load data of the second plane PL2 from the first FIFO memory FIFO1_2 into the second FIFO memory FIFO2. In the second waiting time period tWHR2' of the second operation period OI2, data of the second plane PL2 may be loaded into the second FIFO memory FIFO2.

The memory device 200 may receive the second operation packet OP2. In the second operation period OI2, the memory device 200 may output the data loaded in the second FIFO memory FIFO2 to the outside of the memory device 200 as the transmission data DT based on the second operation execution packet SCE2. Specifically, the clock generator 231 may generate the second clock signal CLK2 based on the second operation execution packet SCE2. In response to the second clock signal CLK2, the data DATA of the second plane PL2 loaded in the second FIFO memory FIFO2 may be output to a memory controller (for example, the memory controller 100 of FIG. 1) as the transmission data DT.

The second waiting time period tWHR2' may be less than the first waiting time period tWHR2. For example, the first waiting time period tWHR2 may be 250 ns, and the second waiting time period tWHR2' may be 60 ns, but this is an example, and the inventive concepts are not limited thereto. Compared to the first waiting time period tWHR2, the second waiting time period tWHR2' may exclude the time required for the data DATA stored in the first plane PL1 to the fourth plane PL4 to be loaded into the first FIFO circuit 221. The memory device 200 may reduce the delay time generated by transmitting and receiving command-addresses respectively corresponding to the plurality of planes, and thus, the I/O efficiency may be further improved. The memory device 200 may also perform operations, which are similar to the operation for the second plane PL2 described with reference to FIG. 9B, for the third plane PL3 and the fourth plane PL4.

FIG. 10 is a timing diagram illustrating an embodiment in which the operation execution packet SCE includes plane order information, according to some example embodiments. In FIG. 10, it is assumed that a memory includes a first plane PL1, a second plane PL2, a third plane PL3, and a fourth plane PL4, and a plane order is sequential from the first plane PL1 to the fourth plane PL4. Redundant descriptions of the planes are omitted below.

The operation packet OP may include the plane order information. In some example embodiments, the operation execution packet SCE may include the plane order information POI on an operation plane. For example, the first operation execution packet SCE1 may include the plane order information POI for the first plane PL1. The second operation execution packet SCE2 may include the plane order information POI on the second plane PL2. The third operation execution packet SCE3 may include the plane order information POI on the third plane PL3. The fourth operation execution packet SCE4 may include the plane order information POI on the fourth plane PL4.

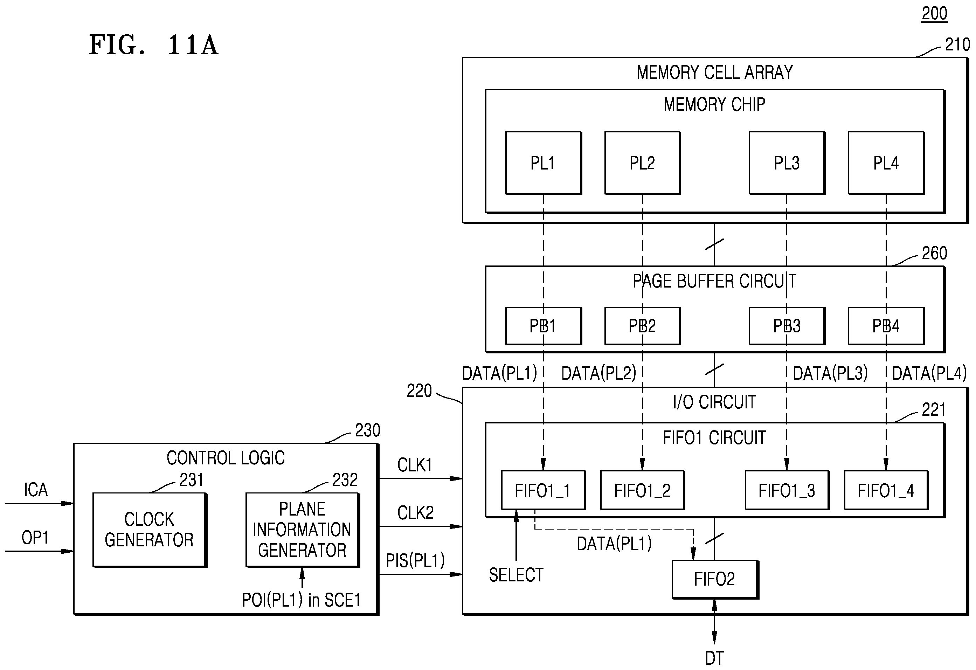

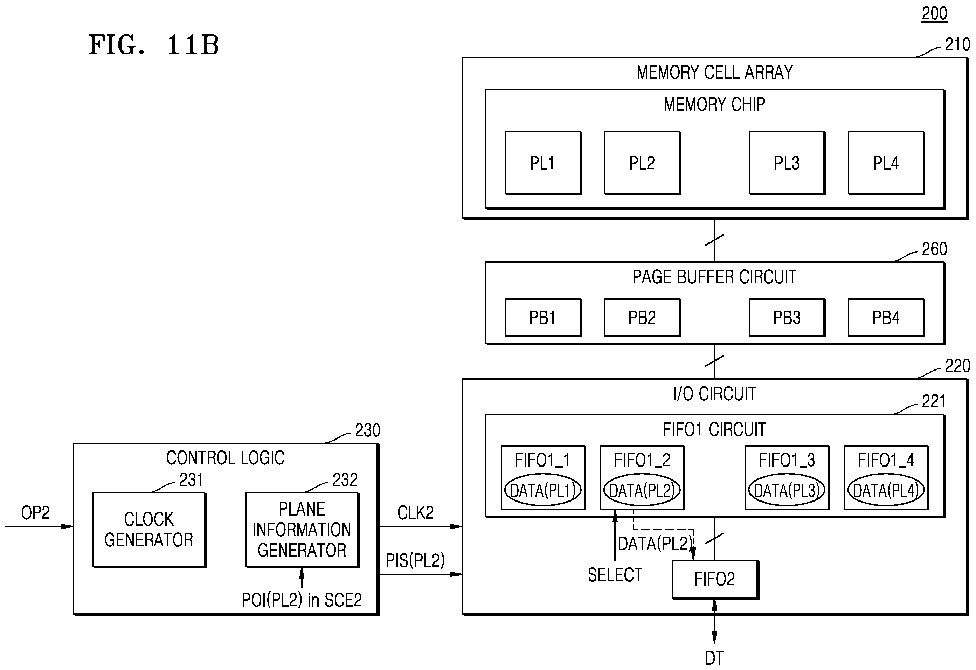

A first operation period OI1 may include a first waiting time period tWHR2, and the memory device 200 may perform an operation based on the plane order information POI included in the first operation execution packet SCE1 in a first waiting time period tWHR2. In the first operation period OI1, the data DATA of the first plane PL1 may be output. A second operation period OI2 may include a second waiting time period tWHR2', and the memory device 200 may perform an operation based on the plane order information POI included in the second operation execution packet SCE2 in the second waiting time period tWHR2'. In the second operation period OI2, the data DATA of the second plane PL2 may be output. The memory device 200 may perform operations, which are similar to the operation in the second operation period OI2, in a third operation period OI3 and a fourth operation period OI4. Hereinafter, the operation of the memory device 200 is described below in detail with reference to FIG. 11A and FIG. 11B.

FIG. 11A is a diagram illustrating an operating method of the memory device 200 in the first operation period OI1 of FIG. 10. Redundant descriptions of the operating method are omitted below. Hereinafter, FIG. 10 and FIG. 11A are referred to together.

Referring to FIG. 11A and FIG. 10 together, the memory device 200 may receive an initial command-address ICA. In the first waiting time period tWHR2, the memory device 200 may load the data DATA stored in the first plane PL1 to the fourth plane PL4 into the first FIFO circuit 221 based on the initial command-address ICA. For example, the clock generator 231 may generate a first clock signal (CLK1) based on the initial command-address ICA. In response to the first clock signal CLK1, a first FIFO memory FIFO1_1 may load the data DATA of a first plane PL1, a first FIFO memory FIFO1_2 may load the data DATA of a second plane PL2, a first FIFO memory FIFO1_3 may load the data DATA of a third plane PL3, and a first FIFO memory FIFO1_4 may load the data DATA of a fourth plane PL4.

The memory device 200 may load the data DATA of the operation plane from the first FIFO memory FIFO1 corresponding to the operation plane to the second FIFO memory FIFO2 based on the operation packet OP. The memory device 200 may receive a first operation packet OP1. In the first waiting time period tWHR2, the memory device 200 may select the data DATA of the first plane PL1 based on the first operation packet OP1 among the data loaded in the first FIFO circuit 221, and load the data DATA of the first plane PL1 into the second FIFO memory FIFO2. Compared to FIG. 9A, the memory device 200 of FIG. 11A may load the data DATA of the first plane OL1 from the first FIFO memory FIFO1_1 to the second FIFO memory FIFO2 based on the first operation packet OP1.

The memory device 200 may switch the planes based on the operation execution packet SCE. In some example embodiments, a plane information generator 232 may generate a plane selection signal PIS for selecting the operation plane based on the operation execution packet SCE. The first operation execution packet SCE1 may include plane order information POI on the first plane PL1. The plane information generator 232 may generate the plane selection signal PIS based on the plane order information POI on the first plane PL1. For example, the plane information generator 232 may generate the plane selection signal PIS for selecting the first plane PL1.

The input/output circuit 220 may select the first FIFO memory FIFO1_1 corresponding to the first plane PL1 in response to the plane selection signal PIS, and load the data DATA of the first plane PL1 from the first FIFO memory FIFO1_1 to the second FIFO memory FIFO2. In the first waiting time period tWHR2, the data DATA of the first plane PL1 may be loaded into the second FIFO memory FIFO2.

The memory device 200 may output the data DATA loaded in the second FIFO memory FIFO2 to the outside of the memory device 200 as the transmission data DT based on the first operation execution packet SCE1. For example, the clock generator 231 may generate the second clock signal CLK2 based on the first operation execution packet SCE1. In response to the second clock signal CLK2, the data DATA of the first plane PL1 loaded in the second FIFO memory FIFO2 may be output to a memory controller (for example, the memory controller 100 of FIG. 1) as the transmission data DT. In the first operation period OI1, the data DATA of the first plane PL1 may be output to the memory controller 100.

FIG. 11B is a diagram illustrating an operating method of the memory device 200 in the second operation period OI2 of FIG. 10. Hereinafter, FIG. 10 and FIG. 11B are referred to together. Redundant descriptions of the operating method are omitted below.

The memory device 200 may receive a second operation packet OP2. In the second waiting time period tWHR2' of the second operation period OI2, the memory device 200 may select the data DATA of the second plane PL2 from among the data loaded in the first FIFO circuit 221 based on the second operation packet OP2, and load the data DATA of the second plane PL2 into the second FIFO memory FIFO2.

The second operation execution packet SCE2 may include plane order information POI on the second plane PL2. The plane information generator 232 may generate a plane selection signal PIS based on the plane order information POI on the second plane PL2. For example, the plane information generator 232 may generate the plane selection signal PIS for selecting the second plane PL2.

The input/output circuit 220 may select a first FIFO memory FIFO1_2 corresponding to the second plane PL2 in response to the plane selection signal PIS, and load the data DATA of the second plane PL2 from the first FIFO memory FIFO1_2 into the second FIFO memory FIFO2. In the second waiting time period tWHR2' of the second operation period OI2, the data DATA of the second plane PL2 may be loaded into the second FIFO memory FIFO2.

The memory device 200 may output the data DATA loaded in the second FIFO memory FIFO2 to the outside of the memory device 200 as the transmission data DT based on the second operation execution packet SCE2. For example, the clock generator 231 may generate a second clock signal CLK2 based on the second operation execution packet SCE2. In response to the second clock signal CLK2, the data DATA of the second plane PL2 loaded in the second FIFO memory FIFO2 may be output to the memory controller as the transmission data DT. The memory device 200 may also perform operations, which are similar to the operation for the second plane PL2 described with reference to FIG. 11B, for the third plane PL3 and the fourth plane PL4.

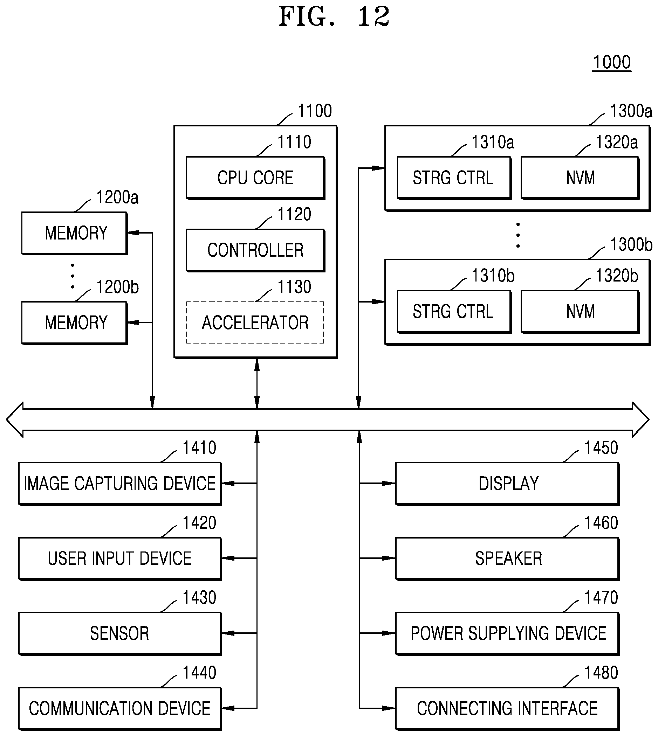

FIG. 12 illustrates a system to which a memory system according to some example embodiments is applied. Non-volatile memory devices (NVMs) 1320a and 1320b of FIG. 12 may be applied to a memory device (for example, the memory device 200 of FIG. 1) described in accordance with the inventive concepts, a controller 1120 of FIG. 12 may be applied to a memory device (for example, the memory controller 100 of FIG. 1) described in the inventive concept, and storage devices 1300a and 1300b of FIG. 12 may be applied to a memory system (for example, the memory system 10 of FIG. 1) described in accordance with the inventive concepts. A system 1000 of FIG. 12 may basically be a mobile system, such as a mobile phone, a smartphone, a tablet personal computer (PC), a wearable device, a healthcare device, or an internet of things (IOT) device. However, the system 1000 of FIG. 12 is not limited to the mobile system and may also be a PC, a laptop computer, a server, a media player, an automotive device such as a navigation system, or so on.

Referring to FIG. 12, the system 1000 may include a main processor 1100, memories 1200a and 1200b, and the storage devices 1300a and 1300b, and may further include at least one of an image capturing device 1410, a user input device 1420, a sensor 1430, a communication device 1440, a display 1450, a speaker 1460, a power supplying device 1470, and a connecting interface 1480.

The main processor 1100 may control all operations of the system 1000, more specifically, operations of other components included in the system 1000. The main processor 1100 may be implemented by a general-purpose processor, a dedicated processor, or an application processor.

The main processor 1100 may include at least one CPU core 1110 and may further include a controller 1120 that controls the memories 1200a and 1200b and/or the storage devices 1300a and 1300b. According to some example embodiments, the main processor 1100 may further include an accelerator 1130 which is a dedicated circuit for a high-speed data operation, such as an artificial intelligence (AI) data operation. The accelerator 1130 may include a graphics processing unit (GPU), a neural processing unit (NPU), and/or a data processing unit (DPU), and may be implemented by a separate chip that is physically independent of other components of the main processor 1100.

The memories 1200a and 1200b may be used as a main memory device of the system 1000 and may include volatile memory, such as SRAM and/or DRAM, but may also include nonvolatile memory, such as flash memory, PRAM and/or resistive RAM (RRAM). The memories 1200a and 1200b may also be included in the same package as the main processor 1100.

The storage devices 1300a and 1300b may function as nonvolatile storage devices that store data regardless of whether power is supplied and may have a relatively large storage capacity compared to the memories 1200a and 1200b. The storage devices 1300a and 1300b may respectively include storage controllers 1310a and 1310b) and the nonvolatile memory devices 1320a and 1320b storing data under the control of the storage controllers 1310a and 1310b. The nonvolatile memory devices 1320a and 1320b may each include flash memory having a two-dimensional (2D) structure or a three-dimensional (3D) vertical NAND (VNAND) structure but may each include other types of nonvolatile memory, such as PRAM and/or RRAM.

The storage devices 1300a and 1300b may be included in the system 1000 while being physically separated from the main processor 1100 or may be included in the same package as the main processor 1100. In addition, the storage devices 1300a and 1300b may each be in the form of a solid state device (SSD) or a memory card to be detachably connected to other components of the system 1000 through an interface, such as a connection interface 1480 described below. The storage devices 1300a and 1300b may each be a device to which a standard specification, such as a universal flash storage (UFS), an embedded multi-media card (eMMC), or non-volatile memory express (NVMe), is applied but are not limited thereto.

The image capturing device 1410 may capture still images or moving images and may be a camera, a camcorder, and/or a webcam. The user input device 1420 may receive various types of data input from a user of the system 1000 and may be a touch pad, a keypad, a keyboard, a mouse, and/or a microphone. The sensor 1430 may detect various types of physical quantities that may be obtained from the outside of the system 1000 and convert the detected physical quantities into electrical signals. The sensor 1430 may include a temperature sensor, a pressure sensor, an optical sensor, a position sensor, an acceleration sensor, a biosensor, and/or a gyroscope sensor.

The communication device 1440 may transmit and receive signals between other devices outside the system 1000 according to various communication protocols. The communication device 1440 may include an antenna, a transceiver, and/or a modem. The display 1450 and the speaker 1460 may function as output devices that respectively output visual information and auditory information to a user of the system 1000. The power supplying device 1470 may appropriately convert power supplied by a battery (not illustrated) built in the system 1000 and/or an external power supply and supply the converted power to respective components of the system 1000.

The connecting interface 1480 may connect the system 1000 to an external device that is connected to the system 1000 and may exchange data with the system 1000. The connecting interface 1480 may be implemented in various interface types, such as ATA, SATA, e-SATA, an SCSI, a SAS, a PCI, PCIe, NVMe, IEEE 1394, a USB, an SD card, an MMC, an eMMC, a UFS, an eUFS, and a CF card interface.

Any or all of the elements described with reference to the figures may communicate with any or all other elements described with reference to the respective figures. For example, any element may engage in one-way and/or two-way and/or broadcast communication with any or all other elements, to transfer and/or exchange and/or receive information such as but not limited to data and/or commands, in a manner such as in a serial and/or parallel manner, via a bus such as a wireless and/or a wired bus (not illustrated). The information may be encoded in various formats, such as in an analog format and/or in a digital format.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

As described above, some example embodiments are disclosed in the drawings and specifications. Although specific terms are used in the specification to describe the example embodiments, the specific terms are used only for the purpose of describing the inventive concepts and are not intended to limit the meaning or the scope of the inventive concepts described in the patent claims. Therefore, those skilled in the art will understand that various modifications and equivalent other example embodiments may be derived therefrom. Accordingly, the true technical protection scope of the inventive concepts should be determined by the technical idea of the appended patent claims.

While the inventive concepts have been particularly shown and described with reference to some example embodiments thereof, it will be understood that various changes in form and details may be made therein without departing from the scope of the following claims.

## Claims

1. A memory device (200) comprising:
a memory cell array (210) including a plurality of planes (PL1, PL2, ... PLk);
a plurality of first first-in first-out memories (FIFO1_1, FIFO1_2, ... FIFO1_k) respectively corresponding to the plurality of planes (PL1, PL2, ... PLk) and configured to store at least some pieces of data stored in the plurality of planes (PL1, PL2, ... PLk); and
a second first-in first-out memory (FIFO2) configured to load at least some pieces of data stored in at least one of the plurality of first first-in first-out memories (FIFO1_1, FIFO1_2, ... FIFO1_k) according to a plane order in which the data stored in the plurality of planes (PL1, PL2, ... PLk) is output,
wherein the memory device (200) is configured to store the data stored in each of the plurality of planes (PL1, PL2, ... PLk) in a corresponding first first-in first-out memory of the plurality of first first-in first-out memories (FIFO1_1, FIFO1 _2, ... FIFO1_k), respectively, based on an initial command-address (ICA) provided from a memory controller (100).

2. The memory device (200) of claim 1, wherein
the memory device (200) is configured to receive an operation packet (OP) for instructing that data loaded into the second first-in first-out memory (FIFO2) is to be output to an outside of the memory device (200), and
the memory device (200) is configured to receive the operation packet (OP) after the initial command-address (ICA) and includes plane order information (POI) indicating a plane order.

3. The memory device (200) of claim 2, wherein the operation packet (OP) includes the plane order information (POI) regarding an operation plane corresponding to the operation packet (OP).

4. The memory device (200) of claim 3, wherein
the memory device (200) is configured to load data of the operation plane from one of the plurality of first first-in first-out memories (FIFO1_1, FIFO1_2, ... FIFO1_k) corresponding to the operation plane into the second first-in first-out memory (FIFO2), based on the plane order information (POI), and
the memory device (200) is configured to output the data of the operation plane loaded in the second first-in first-out memory (FIFO2) to outside of the memory device (200), based on the operation packet (OP).

5. The memory device (200) of claim 2, wherein
the operation packet (OP) includes the plane order information (POI) regarding a subsequent plane, and
the subsequent plane is a plane having a plane order following an operation plane corresponding to the operation packet (OP).

6. The memory device (200) of claim 5, wherein
the memory device (200) is configured to load data of an initial plane from an initial first first-in first-out memory (FIFO1_1) corresponding to the initial plane (PL1) to the second first-in first-out memory (FIFO2), based on the initial command-address (ICA), and
the initial plane (PL1) is a plane of which the plane order is earliest among the plurality of planes (PL1, PL2, ... PLk).

7. The memory device (200) of claim 5 or 6, wherein
the memory device (200) is configured to output data of the operation plane loaded in the second first-in first-out memory (FIFO2) to outside of the memory device (200), based on the operation packet (OP), and
the memory device (200) is configured to load data of the subsequent plane from a subsequent first first-in first-out memory corresponding to the subsequent plane into the second first-in first-out memory (FIFO2), based on the plane order information (POI).

8. The memory device (200) of any one of claims 5 to 7, wherein
the operation packet (OP) includes an operation execution packet (SCE) for instructing to output the data loaded in the second first-in first-out memory (FIFO2) and the operation packet (OP) includes an operation completion packet (SCP) indicating an output completion of the data loaded in the second first-in first-out memory (FIFO2), and
the operation completion packet (SCP) includes the plane order information (POI) regarding the subsequent plane.

9. The memory device (200) of any one of claims 2 to 8, wherein
the memory device (200) further includes a clock generator (231) configured to control the first first-in first-out memories (FIFO1_1, FIFO1_2, ... FIFO1_k) and the second first-in first-out memory (FIFO2), and
the clock generator (231) is configured to generate a first clock signal (CLK1) for controlling the first first-in first-out memories (FIFO1_1, FIFO1_2, ... FIFO1_k), based on the initial command-address (ICA), and generates a second clock signal (CLK2) for controlling the second first-in first-out memory (FIFO2), based on the operation packet (OP).

10. The memory device (200) of any one of claims 2 to 9, wherein the memory device (200) is configured to receive the initial command-address (ICA) and the operation packet (OP) from the memory controller (100) through a command-address bus (CA BUS), and transmit and receive the data (DT) to and from the memory controller (100) through a data bus (DQ BUS).

11. A memory controller (100) configured to control a memory device (200) including a plurality of planes (PL1, PL2, ... PLk), the memory controller (100) comprising:
a command processor (120) configured to generate an initial command-address (ICA) for instructing a memory operation for the plurality of planes (PL1, PL2, ... PLk), the command processor (120) configured to generate an operation packet (OP) corresponding to each of the plurality of planes (PL1, PL2, ... PLk) and the operation packet (OP) configured for instructing the transmission of data stored in a corresponding operation plane to the memory controller (100); and
a memory interface (160) configured to, after the initial command-address (ICA) is transmitted to the memory device (200), transmit the operation packet (OP) corresponding to each of the plurality of planes (PL1, PL2, ... PLk) to the memory device (200) according to a plane order in which data stored in each of the plurality of planes (PL1, PL2, ... PLk) is output.

12. The memory controller (100) of claim 11, wherein the command processor (120) is configured to add plane order information (POI) indicating the plane order to the operation packet (OP).

13. The memory controller (100) of claim 12, wherein
the operation packet (OP) includes an operation execution packet (SCE) for instructing to output data stored in an operation plane corresponding to the operation packet (OP) and the operation packet (OP) includes an operation completion packet (SCP) indicating an output completion of the data stored in the operation plane, and
the command processor (120) is configured to add the plane order information (POI) to the operation completion packet (SCP).

14. The memory controller (100) of claim 13, wherein
the command processor (120) is configured to add the plane order information (POI) regarding a subsequent plane to the operation completion packet (SCP), and
the subsequent plane has a plane order in which the subsequent plane is after the operation plane.

15. The memory controller (100 of claim 12, wherein
the operation packet (OP) includes an operation execution packet (SCE) for instructing to output data stored in an operation plane corresponding to the operation packet (OP) and the operation packet (OP) includes an operation completion packet (SCP) indicating an output completion of the data stored in the operation plane, and
the command processor (120) is configured to add the plane order information (POI) to the operation execution packet (SCE).
